# EUROPEAN PATENT SPECIFICATION

(11) **EP 4 250 005 B1**
(45) Date of publication and mention of the grant of the patent: **25.06.2025**
(21) Application number: 23163531.9
(22) Date of filing: 22.03.2023
(51) Int. Cl.: G03F 1/22, G03F 1/74

(54) **METHOD AND APPARATUS FOR MASK REPAIR**
VERFAHREN UND VORRICHTUNG ZUR MASKENREPARATUR
PROCÉDÉ ET APPAREIL DE RÉPARATION DE MASQUE

(30) Priority: 22.03.2022 DE 102022202803; 04.10.2022 DE 102022210492
(43) Date of publication of application: 27.09.2023
(73) Proprietor: Carl Zeiss SMT GmbH, 73447 Oberkochen (DE)
(72) Inventor: HERMANNS, Christian Felix, 60594 Frankfurt am Main (DE); SPIES, Petra, 55130 Mainz (DE); RHINOW, Daniel, 60487 Frankfurt am Main (DE); RUMLER, Maximilian, 64287 Darmstadt (DE); SCHNEIDER, Horst, 65195 Wiesbaden (DE); TU, Fan, 64807 Dieburg (DE); AHMELS, Laura, 64291 Darmstadt (DE); HERD, Benjamin, 63456 Hanau (DE)
(74) Representative: Bardehle Pagenberg Partnerschaft mbB Patentanwälte Rechtsanwälte

(56) References cited:
- US-A- 5 154 883
- US-A1- 2020 310 245
- US-A1- 2021 048 744

## Description

### 1. Technical field

The present invention relates to methods, to an apparatus and to a computer program for processing of a lithography object. More particularly, the present invention relates to a method for removing a material, to a corresponding apparatus and to a method for a lithographic processing of a wafer, and to a computer program for performing the methods.

### 2. Prior art

In the semiconductor industry, increasingly smaller structures are produced on a wafer in order to ensure an increase in integration density. Among the methods used here for the production of the structures are lithographic methods, which image these structures onto the wafer. The lithographic methods may comprise, for example, photolithography, ultraviolet (UV) lithography, DUV lithography (i.e. lithography in the deep ultraviolet spectral region), EUV lithography (i.e. lithography in the extreme ultraviolet spectral region), x-ray lithography, nanoimprint lithography, etc. Masks are usually used here as lithography objects (e.g. photomasks, exposure masks, reticles, stamps in the case of nanoimprint lithography, etc.), which comprise a pattern in order to image the desired structures onto a wafer, for example.

In the course of a lithographic method, a mask may be subject to high physical and chemical stresses (for example on mask exposure, mask cleaning, etc.). Accordingly, high demands are made on the stability of the mask materials. Over the course of time, particular mask materials have become established for particular mask structures (for example, tantalum or chromium for radiation-absorbing and/or phase-shifting mask structures). For example, the mask materials may be designed such that there is a low layer thickness of an absorber in the mask and/or a specific phase-shifting property of a mask structure. With advancing technical development in lithography, the high demands on the mask materials may, however, become even more severe. In order still to ensure resistant mask materials having, for example, radiation-absorbing and/or phase-shifting properties, alternative mask materials and the production of masks based thereon have recently been examined in the field of lithography.

For example, US 2021/0223681 A1 is directed to production of a reflective mask with which the shadowing effect of a reflective mask can be reduced further and a fine and highly accurate phase-shifting pattern can be formed. It has a substrate, a reflective multilayer film and a phase-shifting film. The phase-shifting film has a first layer and a second layer. The first layer comprises a material containing at least one of the following: tantalum and chromium. The second layer comprises a metal-containing material that contains ruthenium and at least one of the following: chromium, nickel, cobalt, vanadium, niobium, molybdenum, tungsten, rhenium. In one configuration, a protective layer is included between a reflective multiple layer and the phase-shifting film, wherein the protective layer contains ruthenium and the first and second layers are layered atop the protective layer in that sequence.

US 10481484 B2 is directed to production of a reflective mask comprising a reflective multilayer film, a protective film and a phase-shifting film, which are formed on a substrate in that sequence. The protective film is made from a material that contains ruthenium as its main component, and an anti-diffusion layer that contains ruthenium and oxygen. The anti-diffusion layer is formed on one surface of the protective film or is formed as part of the protective film on a side that adjoins the phase-shifting film, in order to prevent thermal diffusion between the protective film and the material of the phase-shifting film.

WO 2021/100383A1 discloses a reflective mask blank with a phase-shifting film in which the change in phase differential and/or reflectivity of the phase-shifting film is small, even when the thickness of the phase-shifting film changes. The reflective mask blank is provided on a main surface of a substrate with a reflective multilayer film and a phase-shifting film in the sequence specified. The reflective mask blank is characterized in that the phase-shifting film has a lower layer and an uppermost layer, wherein the lower layer is positioned between the uppermost layer and the multilayer reflective film. The lower layer is formed from a material having a total content of ruthenium and chromium of 90 atom per cent or more, or a material having a total content of ruthenium, chromium and nitrogen of 90 atom per cent or more. The uppermost layer is formed from a material having a total content of ruthenium, chromium and oxygen of 90 atom per cent or more.

US 2020/310245 discloses a mask repair apparatus capable of efficiently repairing a defect of a target EUVL mask. The mask repair apparatus repairs the defect of the target extreme ultraviolet lithography, EUVL, mask having a reflective layer, a first layer disposed on the reflective layer, and a second layer disposed on the first layer, and a third layer disposed on the second layer. The mask repair apparatus performs etching of the third layer by a first etching method, and after the etching of the third layer by the first etching method, performs etching of the second layer by the second etching method different from the first etching method.

Since mask faults generally cannot be ruled out in complex mask production, however, mask materials may also form as (local) mask faults on the mask (for example as defects, excess material, malformed material, overlying particles, etc.). However, existing methods of mask repair have been designed exclusively for industrially long-established mask materials. The demands on mask production with novel materials are therefore extremely high.

It is therefore the object of the present invention to improve this situation.

### 3. Summary of the invention

This object is at least partly achieved by the various aspects of the present invention.

A first aspect of the invention relates to a method for processing a lithography object in accordance with claim 1.

The invention addresses the problem of removing materials on a lithography object that are designed to be resistant to removal under chemical and/or physical stress. There has recently been discussion as to whether structures in an object for lithography should be produced from a ruthenium-containing material in order to do justice to the current and future demands in lithography. By virtue of the ruthenium-containing material, the structures formed therefrom in the object may have elevated chemical stability to the demands of lithography. A structure in the object may comprise, for example, a three-dimensionally configured geometry in terms of length, width and/or height, a topology step, an elevation, a depression in the object, or any topological variance in relation to a planar plane of the object. For example, the ruthenium-containing material may account for at least one layer of a structure in the object for lithography.

The ruthenium-containing material may have been designed specifically in order to explicitly prevent the removal of the first material under chemical/physical influences. The ruthenium-containing material may also be designed here such that it prevents removal/wear of mask structures formed thereon even under sustained or regular chemical/physical stress. The ruthenium-containing material may, for example, be designed for the extreme conditions in lithography methods under which the object is to be used for lithography. For example, the object may be exposed to a (damaging) plasma during a lithography method. For example, it may be necessary for a lithography method to expose the object to a hydrogen environment (for example for prevention of defects). In the case of lithographic exposure of the object, there may be release of a (parasitic) high-reactivity hydrogen plasma with free hydrogen radicals that can act on the material of the object. The plasma constitutes a high degree of chemical/physical stress on the object and can cause removal of material and damage to the material of the object (for example in a similar manner to plasma etching). However, the material-removing effect is undesirable in the lithography object, since this can adversely affect the properties of the object and hence the quality of the lithography method. Therefore, the ruthenium-containing material of corresponding mask structures may be (explicitly) designed in order to assure high resistance of the first material to the material-removing effect of a plasma (for example especially of the high-reactivity hydrogen plasma). Moreover, the object may be subjected to numerous other mechanical/chemical influences in lithography, which can damage the object (for example in combination with the effect of plasma). For example, the other damaging influences may include severe temperature fluctuations, exposure radiation, and chemical reactions of the object with purge gases. The ruthenium-containing material may therefore typically be designed to fundamentally counteract the totality of the damaging material-removing effects in lithography, such that mechanical/chemical wear and removal of the ruthenium-containing material is made more difficult.

The inventors have recognized that such a ruthenium-containing material can be removed in a particle beam-induced manner in order to correct any defects caused by excess material. The basis of the inventive concept is accordingly to remove materials that are specifically designed to be resistant to removal via a particle beam-based process. The inventors here have hit on the unexpected finding that ruthenium-containing material in a lithography object can be removed with the aid of a provided gas and a provided particle beam (for example via particle beam-induced etching). This was a surprising finding to the inventors since it was not foreseeable that the first material - resistant to the aggressive conditions of the lithography - can be processed in a particle beam-based manner or even removed (for example without the use of a plasma). It was additionally difficult for the inventors to reach this finding since, according to prevailing opinion, ruthenium was previously known as a non-removable protective layer in lithography objects, in order to protect the underlying layers in a (particle beam-based) etching process. In addition, it was unexpected to the inventors in view of the resistant (ruthenium-containing) first material that, in the case of particle beam-based removal of the first material, the provision of a gas comprising first molecules is sufficient. There is not necessarily any need in accordance with the invention to resort to a complex gas mixture (for example comprising different types of molecule designed for the resistant material). This can ensure that complexity in particle beam-reduced removal is reduced, as a result of which, for example, easier process control in the method according to the invention is possible (since, for example, the providing of a single gas constitutes a lesser demand on technical implementation than the providing of a gas mixture of, for example, two or more different gases). The invention accordingly enables processing of lithography objects having mask structures made of a (resistant) ruthenium-containing material. The first material may be designed, for example, such that it withstands, essentially without change, at least 20, at least 50, at least 100 or even at least 1000 cleaning cycles that are undertaken in a (UV, e.g. EUV or DUV) mask cleaning operation (such that for example, in the case of a mask having the first material as part of a pattern element of the mask, no printable errors are generated by the cleaning cycles).

The lithography object as described herein may comprise a lithography mask in this case. The lithography mask may be designed such that it can be used in lithography for the production of semiconductor-based chips (for example on exposure of a semiconductor-based wafer). The lithography mask may also include any type of lithography mask that can image an image based on a source of electromagnetic radiation (of any wavelength) and a pattern encompassed in the lithography mask. The image may comprise a transformation of the pattern. The lithography mask may comprise, for example, an EUV mask, a DUV mask, a UV mask, an x-ray lithography mask, a binary mask, a phase-shifting mask, etc. In addition, the lithography mask may also comprise a nanoimprint lithography stamp, or a lithography mask, that can image a pattern based on a source of particles.

In one example, in the method in the first aspect, the first material is (only) partly removed in the working region. For example, the method can be effected in such a way that, after the (partial) removal of the first material, the first material is still present in the working region. For example, the method (described herein) can remove a significant portion of the first material in the working region. This may comprise, for example, the removing of one or more layers of the first material. In a further example, the removing may generate a topology step (for example a local depression, an edge, etc.) in the first material. The removing (as described herein) may be regarded as a controlled effective removal of material, by contrast with a pure surface conditioning operation, or roughening of the first material (which may occur, for example, when the first material is used as an etch stop layer). For example, the removing can be effected over a depth of at least 10 nm, at least 20 nm or at least 25 nm.

The working region specified herein may comprise a local region of the lithography object. However, it is also conceivable that the working region comprises the entire lithography object. The working region may also include any areal dimension, shape and/or (three-dimensional) geometry. For example, the working region may be within an order of magnitude associated with a particular measurement of the object. For example, the particular measurement may comprise a critical dimension CD of a pattern element of the object. The pattern element may comprise here, for example, part of a mask structure, part of the layers of a mask structure and/or the mask structure itself. The critical dimension CD may comprise, for example, a defined structure with of the pattern element or else a defined distance between two (characteristic) pattern elements. The working region may, for example, form an area A over the critical dimension CV of the pattern element (for example, A may correspond to a function of the critical dimension CV, with A = f(CD); for example, A may be proportional to the critical dimension). In addition, the first material may be removed within the working region such that the first material is not necessarily removed over the entire area of the working region, but is removed (locally) in a subregion of the working region. Alternatively, the removing within the working region can be effected such that the first material is removed over the entire area of the working region. In addition, the first gas may be provided in a controlled manner in a subregion of the working region (for example via a locally positionable gas conduit with a gas nozzle). It is likewise possible for the particle beam to be provided in that it is directed onto a subregion of the working region such that the particles of the particle beam are incident on the subregion. In addition, the method may comprise controlled specific local control and/or focusing of the particle beam in the subregion or within the working region (in order, for example, to locally control reaction of the particle beam-induced etching).

In one example, in the method in the first aspect, the first material is fully removed in the working region. For example, it is possible by means of the method for the first material no longer to be present in the working region after the removal. The first material may accordingly also be removed without residue by means of the method.

In one example, in the method in the first aspect, the first material is capable of absorbing radiation associated with the object. For example, this radiation associated with the object may comprise electromagnetic radiation with a particular wavelength which may be used in a lithography method for which the object is designed. For example, the radiation associated with the object may correspond to an exposure radiation for the object in the lithography method. The particular wavelength of the exposure radiation may be regarded as the lithography wavelength of the object. In one example, the lithography object comprises an EUV mask for an EUV lithography method, wherein the lithography wavelength (i.e. the wavelength of the exposure radiation) in this case may be 13.5 nm. In addition, the radiation may relate, for example, to a DUV lithography method (with, for example, lithography wavelength 193 nm or 248 nm), an i-line lithography method (with, for example, lithography wavelength 365 nm), or any other lithography method (with, for example, a different lithography wavelength) depending on the object.

In one example, the first material has an intrinsic material parameter which can be used to conclude a significant (e.g. high) absorption of the lithography wavelength of the object (e.g. a coefficient of absorption, a magnitude of absorption, an imaginary part of the refractive index of the first material). In one example, the extinction coefficient k of the first material may be at least 0.01, 0.015, or at least 0.018 (or, for example, between 0.01 and 0.02 or 0.015 and 0.18). It is likewise conceivable that the significant absorption may be defined via a (low) reflectivity of the first material. For example, the reflectivity of the first material (for example in the region of the lithographic wavelength) may comprise not more than 25 per cent, preferably not more than 20%, more preferably not more than 17%. In addition, the first material may comprise a material which is typically present in the object in order to absorb the lithography wavelength (e.g. a material corresponding to an absorption layer (for example to a pattern element) of the object).

In a further example, the first material has not just one intrinsic material parameter per se that can be used to conclude a significant absorption. In addition, the first material may be geometrically configured such that it can effectively absorb the radiation associated with the object in a local area of the object. For example, the first material, in a (local) area of the object, may be formed geometrically such that it causes significant absorption of radiation of the lithography wavelength via the absorbing material property thereof and the geometric structure thereof. In this case, the first material in the (local) area may make an imaging contribution in a lithography method since there is an actual (i.e. effective) absorption of the radiation of the lithography wavelength. The geometry of the first material may be defined, for example, via the layer thickness of the material, or via a distance that would be covered by radiation of lithography wavelength in a lithography method through the first material (e.g. an absorption distance). The absorption distance may take account, for example, of the optical diffraction of the radiation of lithography wavelength or a vector of incidence of the exposure radiation. For example, the method may comprise not removing a very thin layer of an absorbing material (i.e. an intrinsically absorbing material), since that thin layer in geometric terms is unable to significantly absorb the radiation of lithography wavelength and hence does not make an actual (i.e. effective) imaging contribution in a corresponding lithography method. For example, the significant absorption may be defined or calculated by the layer thickness or absorption distance of the first material: The layer thickness of the first material may be at least 20 nm, preferably at least 35 nm, more preferably at least 50 nm, most preferably at least 60 nm. The layer thickness of the first material may alternatively be less than 60 nm, for example less than 50 nm or less than 35 nm. Significant absorption may also be described in that the intensity of the radiation of lithography wavelength is attenuated by 70%, preferably 80%, most preferably 90%, in a lithography method (for example across the first material).

According to the invention, in the method in the first aspect, the first material corresponds to a layer material of a pattern element of the object (for example a mask). The first material may take the form of a layer material of the pattern element. In one example, in the method, the layer material corresponds to a material of an absorption layer of the pattern element. The absorption layer may comprise the position of the pattern element which is explicitly set up for the absorbing of the radiation of lithography wavelength. The (ruthenium-containing) first material may be designed here, for example, to enable a low layer thickness of the absorption layer. In addition, the (ruthenium-containing) first material may also be designed, for example, to enable a phase-shifting property of a layer of a structure of the lithography object.

In one example, in the method in the first aspect, the first material further comprises at least a second element. The second element may be regarded here as part of any substance included in the first material (i.e. the second element may, for example, comprise part of a cohesive bond, a chemical element, etc.). The first material accordingly need not necessarily be formed exclusively from ruthenium. The first material may also be described here (stoichiometrically) in the form of RuₐZ_{b} with a > 0, b ≥ 0, where Z represents the at least second element (or one or more further chemical elements).

In a further example, the first material may be formed predominantly from ruthenium. For example, the ruthenium content of the first material may comprise at least 50 atom per cent (at%), at least 70 atom per cent, at least 80 atom per cent, or at least 90 atom per cent.

The unit "atom per cent", as described herein, may relate here to a molar proportion of the corresponding material, where atom per cent indicates, for example, the relative number of particles (e.g. ruthenium atoms) in relation to the total number of particles of the substance (for example total number of atoms of the first material). The atomic percentage may be detected, for example, via secondary ion mass spectrometry, SIMS, and/or Auger electron spectroscopy and/or x-ray photoelectron spectroscopy, XPS (and also, for example, via photoelectron spectroscopy, PES).

The method in the first aspect as described herein is fundamentally also conceivable with a different ruthenium content of the first material, e.g. a ruthenium content of < 50 atom per cent or < 10 atom per cent, or else < 1 atom per cent, and/or at least 10 atom per cent or at least 25 atom per cent.

In one example, in the method in the first aspect, the second element comprises at least one of the following: a metal, a semiconductor. Likewise possible is a combination of metal and semiconductor.

The metal may comprise, for example, a heavy metal, a light metal, a transition metal, a precious metal, a base metal and/or a metal alloy. The metal may comprise, for example, at least one of the following: niobium (Nb), zirconium (Zr), Y (yttrium), titanium (Ti), lanthanum (La), molybdenum (Mo), cobalt (Co) and/or rhenium (Re). In addition, the metal may comprise at least one of the following: tungsten (W), hafnium (Hf), nickel (Ni), vanadium (V), rhodium (Rh), platinum (Pt), chromium (Cr) and/or palladium (Pd).

In one example, the semiconductor comprises a semimetal and/or a compound semiconductor. The semiconductor may comprise here direct and/or indirect semiconductors. For example, the semiconductor may comprise at least one of the following: silicon (Si), germanium (Ge), boron (B), arsenic (As), gallium arsenide (GaAs), aluminium gallium arsenide (AlGaAs), silicon carbide (SiC), gallium nitride (GaN).

It is likewise conceivable that the second element comprises a nonmetal. For example, the nonmetal may comprise at least one of the following: oxygen, nitrogen, phosphorus, hydrogen, carbon, a halogen (e.g. bromine, fluorine, chlorine etc.).

In one example, in the method in the first aspect, the second element comprises at least one of the following: tantalum, chromium, nitrogen, oxygen. In a preferred example, the first material includes ruthenium and oxygen. In a further preferred example, the first material comprises ruthenium, chromium and oxygen. In a further preferred example, the first material includes ruthenium and tantalum.

In one example, in the method in the first aspect, ruthenium forms a chemical compound with the second element (or with the at least one second element). The chemical compound may comprise here, for example, a binary, ternary and/or quaternary chemical compound. In a preferred example, the chemical compound comprises a ruthenium oxide (e.g. RuO). In a further preferred example, the chemical compound comprises a ruthenium-tantalum compound (e.g. RuTa). It is additionally also conceivable that the chemical compound comprises a ruthenium nitride. In addition, at least one of the following binary chemical compounds is conceivable as chemical compound: RuCr, RuNi, RuCo. In a further example, at least one of the following ternary chemical compounds is conceivable as chemical compound: RuCrNi, RuCrCo, RuNiCo. In a further example, at least one of the following quaternary chemical compounds is conceivable as chemical compound: RuCrNiCo.

In one example, in the method in the first aspect, the method is effected in such a way that a second material which may, for example, adjoin the first material (or else may be disposed beneath it) is at least partly exposed in the working region by the removing. Here, the removing of the first material (as described herein) can expose a surface of the second material. The second material may, for example, be the material of a layer that adjoins the first material.

In one example, in the method in the first aspect, the first material and the second material differ in at least one element (or substance). For example, in this respect, the second material may comprise substance B, where substance B is not a constituent of the first material. In a preferred example, the second material does not comprise ruthenium and/or does not comprise the at least second element (as described herein). In a further example, the second material may comprise substance A and substance B, where substance A is a constituent of the first material (for example the at least one second element and/or ruthenium) and where substance B is not a constituent of the first material (for example ruthenium or the at least one second element). Moreover, the first and second materials may be physically disjunct (i.e. no substance in the first material corresponds to any substance encompassed in the second material). For example, in this respect, the first material may consist not only of ruthenium but also of substances C and D, in which case the second material may in this case consist (exclusively) of substances E and F, such that no substance in the first material corresponds to any substance in the second material.

In one example, in the method in the first aspect, the second material comprises tantalum and/or a tantalum compound. The tantalum compound may comprise, for example, a tantalum nitride, a tantalum oxide, a tantalum oxynitride and/or a ruthenium-tantalum compound.

The second material may additionally also comprise any metal and/or any semiconductor. The metal may comprise, for example, a heavy metal, a light metal, a transition metal, a precious metal, a base metal and/or a metal alloy. For example, the second material may additionally also comprise boron and/or arsenic.

It is likewise conceivable that the second material comprises a nonmetal which need not necessarily make up part of the tantalum compound. For example, the nonmetal may comprise at least one of the following: oxygen, nitrogen, phosphorus, hydrogen, carbon, a halogen (e.g. bromine, fluorine, chlorine etc.).

In one example, the second material comprises tantalum and oxygen. In a preferred example, the second material comprises tantalum, oxygen and boron. In a further preferred example, the second material comprises tantalum, oxygen and nitrogen.

It should be noted that the second material need not necessarily be limited to tantalum and/or a tantalum compound. Rather than tantalum and/or the tantalum compound, any metal and/or any semiconductor is additionally also conceivable. In addition, it is also conceivable that the second material comprises an oxide and/or a nitride in general.

In one example, the second material may function as a removal stop (e.g. etch stop) for the removing of the first material. In one example, in the method in the first aspect, the first material is removed selectively, such that the second material (or a material beneath) in the object is essentially not removed. For example, the method may be designed such that, in the removal according to the invention (for example based on particle beam-induced etching), there is selectivity of removal (for example etching selectivity) for the first material over the second material (or a material beneath), for example at least 1.5 to 1; at least 5 to 1; or at least 10 to 1. The selectivity may enable here, for example, removal of the second material (or a material beneath) at a lower removal rate than the first material when the second material (or a material beneath) is subjected to the method (as described herein).

In one example, the method in the first aspect further comprises removing the second material in the working region. The second material may be removed here in a particle beam-based manner (for example via particle beam-induced etching). The providing of the first gas and the providing of the particle beam in the working region of the object may also serve here to remove the second material in the working region. In one example, the first and second materials may be removed in two different removal steps (for example two etch units). In the first removal step, for example, the first material may be removed (as described herein), so as to expose the second material. The first removal step here may be designed to be selective such that the second material is essentially not removed. In other words, for the first removal step, the second material may be designed as removal stop (e.g. etch stop). The second removal step may subsequently comprise the actual removing of the second material. For this purpose, for example, it is possible to adjust process parameters of the particle beam-based method in the first aspect. This may comprise, for example, a change in the providing of the first gas (for example a change in the gas volume flow rate, the gas concentration and/or the gas pressure of the first gas). For example, the second removal step can also be effected with a different gas composition from the first removal step (for example, the first molecules in the second removal step may be different from the first molecules in the first removal step). For the second removal step, there may likewise be a change in parameters of the particle beam (for example a change in the acceleration of the particles, in the particle flow rate, etc.). The second material may accordingly be removed in the second removal step with a different parameter space in the method from the first material in the first removal step.

However, it is also conceivable that the first material and the second material are removed in a single removal step. In this case, for example, there is no need for sequential matching of process parameters that are designed to be material-specific for the first and then the second material. For example, after the removing of the first material and the exposing of the second material, the second material is removed via the method without any need for further material-specific matching of process parameters.

In one example, in the method in the first aspect, the second material is fully removed in the working region. For example, it is possible by means of the method for the second material no longer to be present in the working region (or in the subregion of the working region) after the removal.

In one example, in the method in the first aspect, the method is effected in such a way that a third material which may, for example, adjoin the second material (or else may be disposed beneath it) is at least partly exposed in the working region by the removing of the second material. In one example, the method in the first aspect is designed such that the second material is removed selectively, such that the third material of the object is essentially not removed. The third material may accordingly serve as removal stop (e.g. etch stop) for the removing of the second material. This can ensure, for example, that a material beneath the third material is not attacked by the particle beam-based method.

In one example, in the method in the first aspect, the third material comprises ruthenium. For example, the third material may have the same ruthenium content as the first material (for example as described herein). It is also conceivable here for the third material that it may be formed essentially exclusively from ruthenium. The third material may also comprise features and properties described herein for the first material. In addition, the first material may also comprise features and properties described herein for the third material.

In a preferred example, the third material (as well as ruthenium) may also comprise niobium (Nb).

In one example, in the method in the first aspect, the first and third materials comprise the same elements. For example, the material composition of the first material may correspond to the material composition of the third material. For example, the first material and the third material may consist of the same elements (for example, the first and third materials may each consist of ruthenium and substance B). The material-specific features/properties of the first and third materials may therefore be identical in this example (but it is also conceivable that the proportions of ruthenium and substance B are different in the first and third materials).

In one example, the method in the first aspect further comprises removing at least one intermediate material. The intermediate material may comprise here any material disposed between the first and second materials and/or between the second and third materials. The second material accordingly need not necessarily (directly) adjoin the first material, but may be coupled thereto via the at least one intermediate material. In addition, the third material accordingly need not necessarily (directly) adjoin the second material, but may be coupled thereto via the at least one intermediate material. The intermediate material may correspond here to a material of at least one intermediate layer. For example, it is conceivable that the at least one intermediate layer is disposed between the first and second materials, or between the second and third materials. The at least one intermediate material may have here features and properties described herein for materials of the object (for example, the intermediate material may have features/properties as described herein for the first, second and/or third material).

In one example, in the method in the first aspect, the second and/or the third material corresponds to a layer material of a pattern element and/or to a material of a capping layer of a reflective layer stack of the object (or takes the form of a layer material or a capping layer).

The materials described herein (or the layers formed therefrom) may be elucidated in detail with reference to an illustrative lithography object. The object may, for example, have a characteristic layer structure in which the capping layer adjoins the reflective layer stack (e.g. a Bragg mirror) of the object. The characteristic layer structure may also comprise a buffer layer adjoining the capping layer. There may additionally be a first absorption layer adjoining the buffer layer.

In one example, the buffer layer and the first absorption layer are a layer material of a pattern element (for example, these layers may be part of an absorbing pattern element). The first absorption layer may correspond here to the first material (as described herein), in which case the buffer layer may correspond to the second material (as described herein). The capping layer in this example may correspond to the third material (as described herein).

In a further example, the characteristic layer structure also includes a second absorption layer that adjoins the first absorption layer. The second absorption layer may correspond here to the first material (as described herein), in which case the first absorption layer may correspond to the second material (as described herein). The capping layer in this example may correspond to the third material (as described herein), in which case the buffer layer may correspond to the at least one intermediate material.

The method may be configured with such a selectivity of the removing that the third material (for example the material of the capping layer) is essentially not removed. This can enable controlled ending of the method without attacking the reflective layer stack. The capping layer may accordingly function as a removal stop (e.g. etching stop), such that it is possible to avoid damage to the reflective layer stack that would be associated with damage to the optical properties of the object. For example, a selectivity of removing (for example an etch selectivity) of the second material with respect to the material beneath (for example the third material and/or the at least one intermediate material) may, for example, comprise at least 1.5 to 1; at least 5 to 1; or at least 10 to 1.

In one example, the method in the first aspect further comprises removing at least one surface material of the object. The surface material may comprise, for example, a material of the object having a surface accessible to the first gas and to the particle beam (for example an exposed surface of the object). The surface material may comprise here any material, and is not limited to the substances and proportions of substances of the first material (or second and/or third materials) specified herein. The surface material may be removed here, for example, in order to expose the first material disposed below it for the method according to the invention.

In one example, the first gas may be regarded as a main etching gas for the removal of the first material. The first gas here may be designed such that it has a substantial influence on the etching characteristics of the first material. For example, the molecules of the first gas may be chosen such that they bring about an etching/removing effect on the first material. The first molecules may also be chosen such that they bring about an etching/removing effect on the first material in conjunction with a reaction which is induced by the particle beam.

In one example, in the method in the first aspect, the first molecules comprise a halogen atom. The inventors have recognized that a gas is especially suitable for the removing of the (ruthenium-containing) first material, which comprises molecules including a halogen. Such a first gas (i.e. etching gas) in conjunction with the particle beam provided can remove the resistant first material advantageously in a technically desirable manner. For example, such a first gas can avoid removal residues, long etching times, inhomogeneous material removal in the method in the first aspect.

In one example, in the method in the first aspect, the first molecules comprise a halogen compound. For example, the halogen compound may comprise a chemical compound including at least one halogen atom, where the halogen atom forms a chemical compound with at least one further chemical component (for example any further chemical element/atom and/or a further chemical substance group/substance compound, etc.). In one example, the halogen compound may comprise exclusively halogens of the same type (for example, the first molecules may comprise F₂, Cl₂, Br₂, etc.).

In one example, in the method in the first aspect, the first molecules comprise a noble gas halide. For example, the noble gas halide may comprise a chemical compound including at least one halogen atom and at least one noble gas atom.

In one example, in the method in the first aspect, the noble gas halide comprises at least one of the following: xenon difluoride, XeF₂, xenon dichloride, XeCl₂, xenon tetrafluoride, XeF₄, xenon hexafluoride, XeF₆. The inventors have recognized here that such noble gas halides too (e.g. xenon difluoride in particular), in the context of the method in the first aspect, can advantageously remove the resistant first material in a technically desirable manner.

In a further example, the first molecules comprise a quadrupole moment (or a multipole moment with at least four poles) of greater than zero. For example, xenon difluoride may have a quadrupole moment greater than zero.

In one example, the first molecules comprise polar molecules. It has been found that polar molecules having a dipole moment may be suitable in principle for the process. In a further example, the first molecules may alternatively comprise nonpolar molecules. The invention is also based on the concept that nonpolar molecules without a dipole moment may also be suitable in principle for the process. In an additional example, the first molecules comprise triatomic molecules. According to the invention, there is not necessarily any need for complex compounds having more than three atoms per molecule for a suitable method in the first aspect.

In one example, the method in the first aspect further comprises: providing a second gas comprising second molecules, wherein the removing of the first material is also based at least partly on the second gas. The second gas described herein may be regarded in this context as additive gas in relation to the main etching gas (i.e. the first gas). The second gas can further influence the removing or particle beam-induced etching of the first material as additive gas and, for example, more accurately adapt process parameters/results (e.g. etch rate, anisotropy factor, selectivity, sidewall angle, surface roughness, etc.). In principle, the molecules described herein for the providing of the first gas may also be applicable to the providing of the second gas, and vice versa.

In one example, the removing of the second material, of the third material, of the intermediate material and/or of the surface material may also be based on the (providing of the) second gas.

In one example, in the method in the first aspect, a dipole moment associated with the second molecules comprises at least 1.6 D, preferably at least 1.7 D, more preferably at least 1.8 D, most preferably at least 1.82 D.

The inventors have recognized that this circumstance can be advantageous in the removing of the first material. In the particle beam-based removal, what is typically required is a defined (local) gas concentration over a particular period of time, in order to allow the removal reaction to run in a defined manner. On account of chemical and/or physical interactions in the removing of the first material, however, the defined (local) gas concentration may vary to a technically undesirable degree. This is of increased importance especially in the case of use of a more complex gas mixture comprising at least two gases (e.g. the first gas and the second gas). This is associated with elevated demands on the maintenance of the defined (local) gas concentration. For example, it is possible here for an increased degree of (local) depletion of the second gas (and/or of the first gas) to occur within the working region, such that the removing of the first material can be influenced in an unwanted manner. The inventors have recognized here that the using of second molecules with the dipole moments specified herein enables optimized conditions in the configuration of the defined (local) gas concentration in the use of the first and second gases. It is thus also possible to optimize the removing of the first material in a controlled manner.

In one example, the method comprises taking account of the dipole moment of the second molecules as a parameter in the removing of the first material. For example, the dipole moment of the second molecules may define a process parameter (for example a gas volume flow rate of the first and/or second gas) in the removing operation. For example, the gas volume flow rate may be selected depending on the dipole moment.

In one example, the method comprises providing the first gas and the second gas at least partly simultaneously. For example, the first gas and the second gas may be introduced simultaneously into the environment of the working region or into the environment of the object, for example during the removal of the first material. This may also comprise the (at least partial) presence of a first gas volume flow rate of the first gas and of a second gas volume flow rate of the second gas during the removal, such that the presence of both gases in the environment of the working region/object is assured. It is possible here, for example, that the first and second gas volume flow rates are essentially identical. In other examples, they may alternatively be different. The simultaneous provision of the first and second gases may also comprise variation of the first gas volume flow rate and of the second gas volume flow rate (in the removal of the first material).

In one example, the method comprises providing the first gas and the second gas at least partly with a time interval. For example, it may be necessary for the removal of the first material for only one of the two gases to be provided or introduced in the environment of the working region/object in a method step of removing. For example, it may be necessary for commencement of the removing of the first material for the first gas only (or the second gas) to be introduced at first into the environment of the working region/object. Subsequently, the second gas (or the first gas) may be fed in or provided at a later juncture. In addition, it is also conceivable that, during the removing, there is stepwise alternation between the (exclusive) providing/introducing of the first gas (without the second gas) and the (exclusive) providing/introducing of the second gas (without the first gas). Furthermore, it is also possible that an end of the process of removing the first material comprises the exclusive providing/introducing of one of the two gases. For example, it is conceivable that an end of the process of producing is defined by the exclusive providing/introducing of the second gas.

In one example, in the method in the first aspect, the second molecules comprise water, H2O, and/or heavy water, D2O. For the removing of the resistant first material, water and/or heavy water has been found to be an advantageous additive gas here. For example, such an additive gas can also optimize the selectivity of the removing of the first material with respect to the second material (or the third material). In a particularly advantageous example, the method comprises XeF₂ as the first gas and H₂O as the second gas. In a further example, the second molecules of the second gas may also comprise semi-heavy water, HDO.

In a further example, the second gas (or the second molecules) may comprise an oxygen-containing component, a halide and/or a reducing component. The oxygen-containing component may include, for example, an oxygen-containing molecule. For example, the oxygen-containing component may comprise at least one of the following: oxygen (O₂), ozone (O₃), hydrogen peroxide (H₂O₂), dinitrogen monoxide (N₂O), nitrogen monoxide (NO), nitrogen dioxide (NO₂), nitric acid (HNO₃). The halide may include, for example, at least one of the following: Cl₂, HCl, XeF₂, HF, I₂, HI, Br₂, HBr, NOCl, NOF, ClNO₂, FNO₂, PCl₃, PCl₅, PF₃, PF₅. The reducing component may comprise here a molecule having a hydrogen atom. For example, the reducing component may comprise at least one of the following: H₂, NH₃, (NH₂)₂, CH₄. In one example, the second gas may comprise water (and/or heavy water) and nitrogen dioxide.

In one example, in the method in the first aspect, the particle beam is based at least partly on an acceleration voltage of less than 3 kV, preferably less than 1 kV, more preferably less than 0.8 kV, most preferably less than 0.6 kV. The method in the first aspect (as described herein) can advantageously be effected in these ranges of acceleration voltage. For example, in this parameter space, the first material can advantageously be removed with the particle beam. In one example, the particle beam is also based on an acceleration voltage of at least 0.1 kV, preferably at least 0.15 kV, even more preferably at least 0.2 kV, most preferably at least 0.3 kV.

In addition, it is also conceivable that the particle beam is based on an acceleration voltage of less than 30 kV, preferably less than 20 kV. In one example, an acceleration voltage between 3 kV and 30 kV may be employed for imaging purposes within the process (in the case of imaging before after the removal and/or imaging during the removal).

In one example, the particle jet comprises a current between 1 pA and 100 pA, preferably between 5 pA and 80 pA, most preferably between 10 pA and 60 pA.

In one example, in the method in the first aspect, the method is at least partly based on a temperature associated with the first and/or second gas. The temperature may be predetermined. The temperature may, for example, be below 0°C (or below 273.15 K), preferably below -5°C (or below 268.15 K), more preferably below -10°C (or below 263.15 K), most preferably below -15°C (or below 258.15 K). The temperature associated with the first and/or second gas may, for example, correspond to a temperature to which a respective reservoir vessel comprising the first (or second) gas is (actively) heated. The respective reservoir vessel may serve here as source or storage means, from which the first (or second) gas is made available for the providing. For example, the providing (as described herein) may be effected from a first reservoir vessel comprising the first gas, or else from a second reservoir vessel comprising the second gas. The temperature of the respective reservoir vessel can be controlled here, for example, by means of Peltier elements. In one example, the temperature specified herein comprises a temperature of the first (or second) gas in the respective reservoir vessel before the (actual) providing of the first (or second) gas for the method (as described herein). This can make it possible for the first (or second) gas to be provided from a source comprising a gas with a defined gas temperature, as a result of which the method can be implemented, for example, in a defined and also reproducible manner. It should be mentioned that, in an example comprising the providing of the first (or second) gas, the temperature of the first (or second) gas in the working region need not necessarily correspond to the temperature of the first (or second) gas in the respective reservoir vessel. For example, the providing (for example comprising gas transport of the first (or second) gas from the respective reservoir vessel via a gas conduit to the working region) can result in a change in the temperature of the first (or second) gas. However, the providing from a source with a defined gas temperature (as described herein) also allows the gas temperature of the gas provided (for example in the working region) to be configured in a defined and reproducible manner.

In a further example, the temperature (specified herein) associated with the first and/or second gas may correspond to a temperature of a (solid and/or liquid) precursor, in which case the first (or second) gas for the method may be formed from the at least one precursor. For example, the precursor may comprise a solid and/or liquid starting material from which the first (or second) gas is produced by means that are familiar in industry. The temperature (specified herein) may serve here to adjust and/or to control a vapour pressure of the solid and/or liquid precursor, in order to form the first (or second) gas by the means that are familiar in industry. The temperature may be adjusted/controlled here, for example, by means of Peltier elements. The temperature (specified herein) may correspond here to a temperature of a reservoir comprising the precursor. The reservoir (i.e. precursor reservoir) may, for example, be designed exclusively for the precursor. In a further example of the invention, the precursor reservoir may likewise serve as reservoir vessel for the first (or second) gas. In addition, the precursor reservoir may also be coupled to a separate reservoir vessel for the first (or second) gas, in which case the first (or second) gas, after formation in the precursor reservoir, is introduced into the separate reservoir vessel (and, for example, stored therein).

In addition, it is also conceivable in one example that the temperature associated with the first and/or second gas comprises a temperature within the environment of the object (for example in the working region of the method described herein or in a process chamber in which the object for the method is disposed). For example, this may comprise the temperature of the first (or second) gas in the environment of the object. It is also conceivable in a further example that the object is brought to the temperature (specified herein) during the method, for example by means of an appropriate object holder (e.g. a temperature-controllable chuck). In this example in particular, it is also conceivable that a predetermined temperature of > 0°C is chosen.

In one example, the method further comprises determining an endpoint of the removing based at least partly on detecting electrons that are released from the object. For example, the electrons may be released on account of an interaction of the particle been provided with an object material or with a working region material. These may be electrons that exit from a region of action of the particle beam incident on the material, for physical reasons, on account of the particle beam. In one example, the electrons comprise scattered electrons and/or secondary electrons. The scattered electrons may comprise, for example, electrons backscattered by the object (backscattered electrons, i.e. BSE) and/or electrons forwardscattered by the object (forwardscattered electrons, i.e. FSE). The electrons detected may provide information about a material property in the region of action of the particle beam, which makes it possible to conclude the material processed by the particle beam. For example, the determining of the endpoint may comprise using the electrons detected to ascertain that the particle beam is not/no longer acting on the first material. This may indicate that the first material has been removed and the endpoint of the process (i.e. the end of the process) has been attained. In addition, the determining of the endpoint may comprise using the electrons detected to ascertain that the particle beam is processing the second and/or the third material. It is thus possible, for example, to determine the end point of the removing of the first material and/or the end point of the removing of the second material. In principle, the electrons detected can be used to determine the material currently being processed by the particle beam without this being based on the determination of the endpoint (for example for process monitoring, as a protocol of the process history, etc.). The particle beam may also be configured such that there is a sufficient difference in signal of the electrons detected depending on the material in the region of action (for example via an acceleration voltage, current, etc.).

In one example, in the method in the first aspect, the particle beam comprises an electron beam. For example, the removing described herein, in the context of the method, may comprise electron beam-induced etching (known, for example, as (F)EBIE - (focused) electron beam induced etching).

However, it is also conceivable that the particle beam comprises an ion beam (for example of gallium ions, helium ions, etc.). For example, the removing of the first material may be based on ion beam-induced machining/etching (e.g. focused ion beam (FIB) milling). As well as the use of solid particles, it is also conceivable to use a particle jet of zero-mass particles (e.g. photons).

In addition, use of multiple particle beams as particle beam is also conceivable.

In one example, the method is effected in such a way that a sidewall angle (of an edge, for example, of a structure) of the first (or second) material is 70° to 90°, preferably 74° to 90°, more preferably 78° to 90°, most preferably 80° to 90°. The sidewall angle may be based here, for example, on the plane of a layer disposed beneath the first (or second) material, or else on the (planar) plane of the object.

In one example, the method is effected in such a way that the exposing of the second material (via the removing of the first material) gives a surface of the second material having a square roughness, RMS, of less than 3 nm, preferably less than 2 nm, more preferably less than 1 nm, most preferably less than 0.5 nm.

In one example, the method is effected in such a way that the exposing of the third material (via the removing of the first and second materials) gives a surface of the third material having a square roughness, RMS, of less than 3 nm, preferably less than 2 nm, more preferably less than 1 nm, most preferably less than 0.5 nm.

In one example, the method in the first aspect is effected in such a way that a defect of the object is repaired. For example, the method may comprise repairing an opaque defect of the object.

An opaque defect here is a faulty site on the lithography object that should actually not be opaque, i.e. clear, according to the design of the object (e.g. transparent or designed such that there is no specific absorption for a radiation of a particular wavelength, for example the lithography wavelength). An opaque defect may also be regarded as a faulty site on the object which is not supposed to comprise any material of a pattern element according to the design of the object, but an (unwanted) material is present at the site. The (unwanted) material present may, for example, comprise a material of the pattern element, although it is also conceivable that it is a different (unwanted) material having a radiation-absorbing and/or phase-shifting effect. A clear defect, by contrast, is a faulty site on the lithography object that should actually be opaque according to the design of the object (e.g. nontransparent or strongly absorbing for a radiation of a particular wavelength, for example the lithography wavelength). A clear defect may also be regarded as a faulty site on the object which is supposed to comprise a material of a pattern element according to the design of the object, but no material is present at the site, or the material of the pattern element is absent. In particular, opaque may be defined in relation to a lithography method for the object. For example, the lithography object may comprise an EUV mask for an EUV lithography method, in which case "opaque" may refer in this case to the lithography wavelength of 13.5 nanometres. It is also conceivable that "opaque" relates to a DUV lithography method (at a lithography wavelength, for example, of 193 nanometres or 248 nanometres), an i-line lithography method (at a lithography wavelength, for example, of 365 nanometres), or any other lithography method depending on the object. In addition, an opaque defect may comprise, for example, a faulty site having opaque material of a layer of a lithography mask (for example, this may comprise a layer designed as a layer for an opaque pattern element of the object). The method here may comprise removing the first material such that the faulty site is no longer opaque.

For example, the repair of the defect may comprise firstly localizing the defect (for example via a scanning electron microscope, an optical microscope, etc.). It is possible here to define the working region which is used for the removing of the first material on the basis of at least one characteristic of the localized defect (for example based on a position, shape, size, type of defect, etc.). The remedying of the defect in the object may further comprise producing a repair mould encompassing the defect. In one example, the repair mould may serve as the working region for the method specified herein. The repair mould may have, for example, a pixel pattern, which can enable localization of a defect site. The pixel pattern may, for example, be designed such that it follows the outline of the defect, such that every pixel in the pixel pattern corresponds essentially to a site in the defect and hence constitutes a defect pixel. In another example, the pixel pattern has a fixed geometric shape (e.g. a polygon, a rectangle, a circle, etc.) which fully encompasses the defect, in which case not every pixel necessarily constitutes a defect site. It is possible here for the pixel pattern to include defect pixels corresponding to a defect site, and non-defect pixels corresponding to a site which does not cover part of the defect. In one example, the method comprises directing the particle beam at least onto a defect pixel of the pixel pattern of the repair mould in the producing of the material. In addition, the particle beam may be configured such that it can be directed onto any defect pixel in the removing of the first material (or the removing of the second material). This can ensure that the removing of the first (or second) material is locally restricted to the defect pixel and hence only the defect is processed.

In a further example, the method may be used in processing of the object which comprises local production of a material. The processing, and the local production of material, can be effected, for example, in the context of defect processing in an object (for example in a repair of a clear defect and/or a defective site, in a removal of a particle, etc.). Thus, the first material need not necessarily be a layer material of the object. The production of material may comprise, for example, the deposition of a material corresponding to the properties of the first material (as described herein). For example, in the course of local production of material, there may be incorrect production of the first material. Accordingly, by means of the method according to the invention, the incorrectly produced material may be removed as first material (as described herein). For example, it may also be necessary in the course of a complex repair to specifically produce the first material, and also to remove it in a controlled manner (for example, this may be necessary when the first material has been produced as a sacrificial layer).

In one example, in the method in the first aspect, the object comprises an EUV mask and/or a EUV mask. For example, the characteristic layer structure described here may correspond to a layer structure of an EUV mask.

A variation relates to a method of processing a lithography object, comprising the following steps: providing a first process gas; providing a particle beam in a working region of the object for removal of the first material in the working region based at least partly on the first process gas; wherein the first material comprises ruthenium.

The process gas may be considered here to be a gas or a gas mixture which is essentially present (for example in the working region) and/or is supplied in the reaction for the removing from the material. The first process gas may comprise, for example, the first gas, or the first and second gases (as described herein). The first process gas may thus include, for example, a substantial etch gas or a substantial etch gas and an additive gas (as described herein).

The variation can be combined with features of the first aspect. In addition, features described in relation to the variation may be combined with the first aspect.

In one example, the first process gas may comprise xenon difluoride molecules. In this case, the first process gas may thus, for example, comprise or correspond to the first gas, the first molecules of which include xenon difluoride molecules.

In one example, the first process gas may further comprise water molecules. The first process gas may thus, for example, as well as the first gas, also comprise the second gas (described herein), the second molecules of which may include water molecules. By means of technical control of the water molecules in the first process gas (for example via adjustment of the gas concentration, of the gas flow rate, etc.; for example by means of a controllable gas conduit), the removing of the first material can be enabled in a controlled manner (as described herein). Process parameters and results in the removing of the first material can thus be adapted in a target-oriented manner (for example with regard to etch rate, anisotropy factor, (material) selectivity, sidewall angle, surface roughness, etc.).

In one example, the method may further, alternatively or additionally, comprise:
providing a second process gas; providing the particle beam in the working region for removal of a second material in the working region based at least partly on the second process gas; wherein the second material comprises tantalum. The second process gas may also be regarded here analogously to the first process gas. The second process gas may comprise, for example, the first gas, or the first and second gases (as described herein). The second process gas may thus include, for example, a substantial etch gas, or a substantial etch gas and an additive gas (as described herein). The removing of the second material may be of significance on its own, or else may be combined with the removing of the first material.

The first material (or a corresponding first layer in the working region) may thus be removed, for example, via particle beam-induced reaction with the first process gas. The second material (or a corresponding second layer in the working region) may, by contrast, be removed via particle beam-induced reaction with the second process gas. Each material (or each layer) may accordingly be removed in the working region via a separate particle beam-based reaction.

The first process gas and the second process gas may be different from one another here. The difference may be caused here by different components of the gas. For example, the first process gas may comprise component A (for example a first noble gas halide), and the second process gas may comprise component B (for example a second noble gas halide). However, the first process gas and the second process gas may also include the same components, provided that they differ in at least one component. For example, the first process gas and the second process gas may comprise one and the same noble gas halide, although the first process gas additionally comprises a further component not included in the second process gas.

For example, the second process gas may comprise xenon difluoride molecules. The xenon difluoride molecules may be regarded, for example, as substantial etch gas (as described herein).

In one example, the second process gas may further comprise nitrogen dioxide molecules. The nitrogen dioxide molecules may be regarded, for example, as an additive gas or as components of an additive gas (as described herein).

In one example, the second process gas may further comprise tetraethyl orthosilicate molecules.

The tetraethyl orthosilicate molecules may be regarded, for example, as an additive gas or as components of an additive gas (as described herein).

In one example, the second process gas comprises xenon difluoride molecules, nitrogen dioxide molecules and tetraethyl orthosilicate molecules. This gas mixture as second process gas has been found to be particularly advantageous in order to remove the second (tantalum-containing) material by the method described herein. It is possible here for the xenon difluoride molecules to function as substantial etch gas, where the nitrogen dioxide molecules may function as additive gas together with the tetraethyl orthosilicate molecules. The additive effects of the nitrogen dioxide molecules and the tetraethyl orthosilicate molecules may thus be combined in the removing of the second material.

In one example, the method may also alternatively or additionally comprise: providing the particle beam in the working region for removing of a further material in the working region based at least partly on the second process gas; wherein the further material comprises tantalum; wherein the further material has a different material composition from the second material. The further material may comprise, for example, substances and/or elements of the third material (described herein), although the further material need not necessarily comprise ruthenium. In the course of and/or before the removing of the second material, the second process gas may be provided separately. However, the second process gas may also be provided continuously with the removing of the second material and the further material, such that this need not be provided separately or again. The removing of the further material may be of significance on its own, or else in combination with the removing of the first and/or second material.

The first, second and further materials may be configured, for example, as described herein with reference to the first aspect.

In one example, the molar proportion of ruthenium in the first material may be higher or essentially the same compared to a molar proportion of one or all other elements included in the first material (for example in atom per cent). For example, the molar proportion of ruthenium may be represented by R, and the proportion of further substances in the first material by, for example, X for a substance 1, Y for a substance 2. The molar proportion R may thus, for example, be essentially the same by comparison with the other molar proportions (e.g. R = X = Y). The molar proportion R may however alternatively also be higher by comparison with the other elements (e.g. R > X and/or R >Y). Therefore, the molar proportion of ruthenium may also form the relative majority of the first material. For example, the molar proportion of ruthenium may alternatively form the absolute majority of the first material (e.g. R > 50 atom per cent), as described herein. For example, the molar proportion of ruthenium may also be below 50 atom per cent, as described herein. The molar proportion may be reported here (as described herein) in atom per cent. The molar proportion in some examples may be chosen such that the ruthenium dominates the phase-shifting properties of the first material (for example in the EUV region).

In one example, the molar proportion of tantalum in the second material may be higher or essentially the same compared to a molar proportion of another element included in the second material. For example, the molar proportion of tantalum in the second material may also form the relative majority of the second material. For example, the molar proportion of tantalum in the second material may alternatively form the absolute majority of the second material. For example, the molar proportion of tantalum in the second material may be at least 50 atom per cent, preferably at least 60 atom per cent, more preferably at least 70 atom per cent, most preferably at least 90 atom per cent.

In one example, the second material may also comprise oxygen, boron and/or nitrogen.

In one example, the second material may include at least one of the following: tantalum oxide (e.g. TaO), tantalum boroxide (e.g. TaBO), tantalum nitride (e.g. TaN), tantalum boronitride (e.g. TaBN).

In one example, the molar proportion of tantalum in the further material may be higher or essentially the same compared to a molar proportion of another element included in the further material. For example, the molar proportion of tantalum in the further material may also form the relative majority of the further material. For example, the molar proportion of tantalum in the further material may be at least 50 atom per cent, preferably at least 60 atom per cent, more preferably at least 70 atom per cent, most preferably at least 90 atom per cent.

In one example, the further material may include at least one of the following: tantalum oxide, tantalum boroxide, tantalum nitride, tantalum boronitride.

In one example, the second material comprises tantalum boroxide (e.g. TaBO) and the further material comprises tantalum boronitride (e.g. TaBN).

In one example, the particle beam may comprise an electron beam.

In one example, the method may further comprise:
determining an endpoint of a removing of a material based at least partly on detecting of electrons that are released from the working region. The electrons detected may comprise, for example, primary electrons and/or secondary electrons.

In one example of the method, a material may be removed at least partly over a predetermined period of time. For example, the duration for a parameter space of the method may be determined experimentally (for example by means of performing the method with multiple durations in order to determine when a material (for example with a particular thickness) has been removed). For example, the predetermined duration may correspond to a predetermined thickness of the material.

In one example of the method, the material removed may comprise a layer material of a pattern element (for example described herein) of the object. The pattern element (for example a multilayer pattern element) may be disposed here atop a capping layer (which covers a large area and is essentially unstructured) of the object. In one example, the pattern element comprises a layer sequence with a first layer comprising the first material; a second layer (for example an adjoining second layer) comprising the second material; a third layer (for example adjoining the second layer) comprising the further material. For example, the third layer may be the lowermost layer here that adjoins the capping layer of the object. For example, the pattern element may be designed such that the first layer thereof comprises ruthenium, the second layer thereof comprises tantalum boroxide (e.g. TaBO), and the third layer thereof comprises tantalum boronitride (e.g. TaBN).

It should be mentioned that the layer sequence of the pattern element may also comprise further layers. For example, it is possible for one or more layers to be disposed above the first layer and/or one or more layers to be disposed between the third layer and the capping layer. For example, there may be one or more antireflection layers atop the first layer described herein. In addition, it is also possible for one or more layers to be disposed between the first and second layers and/or one or more layers to be disposed between the second and third layers. In addition, it is also conceivable that the first, second and third layers may be arranged in any sequence within the (multilayer) pattern element, and not necessarily in the sequence of first layer, second layer, third layer. For example, the layer sequence may also comprise one of the following sequences: first layer, third layer, second layer and/or second layer, third layer, first layer and/or second layer, first layer, third layer and/or third layer, second layer, first layer and/or third layer, first layer, second layer. In some examples, it is also possible only for one or only two of the first, second and third layers to be provided. In these examples too, there may be one or more further layers within the layer sequence. For example, the one or more further layers may separate the first, second and/or third layers mentioned herein from one another. In addition, it is also possible for there to be one or more antireflection layers (or one or more further layers) atop the first, second and/or third layer.

The first layer comprising the first (ruthenium-containing) material may be designed to be predominantly phase-shifting for the corresponding lithographic wavelength (for example an EUV wavelength of, for example, 13.5 nm). The second layer comprising the second (tantalum-containing) material may be designed to be predominantly radiation-absorbing for the corresponding lithographic wavelength (for example an EUV wavelength of, for example, 13.5 nm). The third layer comprising the third (tantalum-containing) material may be designed to be predominantly radiation-absorbing for the corresponding lithographic wavelength (for example an EUV wavelength of, for example, 13.5 nm). For example, the (real) refractive index n of the first layer may be greater than the (real) refractive index of the second and/or third layer. For example, the real part of the refractive index (typically reported as n) of the first layer (or of the first material) may be greater than the real part of the refractive index of the second and/or third layer (or of the second and/or third material). For example, the imaginary part of the refractive index (i.e. the extinction coefficient k) of the first layer (or of the first material) may be smaller than the extinction coefficient of the second and/or third layer (or of the second and/or third material).

A second aspect relates to an apparatus for processing a lithography object, comprising: means of providing a first gas; means of providing a particle beam in a working region of the object, wherein the apparatus is configured to execute a method in the first aspect. In addition, the apparatus may comprise means of executing a computer program (e.g. a computer system, a computation unit, etc.). The apparatus may correspond essentially to a scanning electron microscope that can provide an electron beam as particle beam on the object. The scanning electron microscope may be configured such that it can provide the gases described herein. The first gas (and/or the second gas) may be stored, for example, in corresponding reservoir vessels and be guided via a gas supply system (e.g. a gas conduit with a gas nozzle) within the working region of the object. The apparatus may further include a control system set up to perform the method in an automated manner.

In addition, the apparatus may alternatively or additionally comprise a means of providing a first and/or second process gas (as described herein).

A third aspect relates to a lithography object, wherein the object has been processed by a method in the first aspect. It is possible here, for example, via an optical analysis of the sample, to detect whether the object has been processed by a method in the first aspect. For example, for the lithography object, an optical analysis may initially have been conducted, or may be undertaken (for example in the course of defect qualification of the object, for example after production of the object and/or in the case of introduction of the object into a semiconductor works). The optical analysis may be based, for example, on an optical or particle-based microscope (for example on a mask metrology apparatus, a mask microscope) and, for example, an imaging operation. In processing of the object in one example of the first aspect, after the initial analysis, the first (or second) material may have been removed here as described herein. The removal of the first (or second) material can be detected via a repeated visual analysis (for example in the course of a repair check or another defect qualification). The detection may be effected, for example, via a comparison of the initial visual analysis with the repeated visual analysis (for example via a comparison of the corresponding images). In addition, the detection in the method may also be based on a material analysis of the object (for example Auger spectroscopy, x-ray spectroscopy, etc.), which, for example, is executed in a supplementary manner with the initial or repeated visual analysis.

A fourth aspect of the invention relates to a method of processing a semiconductor-based wafer. The method in the fourth aspect further comprises lithographic transfer of a pattern associated with a lithography object to the wafer, wherein the object has been processed by a method in the first aspect. The lithographic transfer may comprise a lithography method for which the object is designed (e.g. EUV lithography, DUV lithography, i-line lithography, etc.). For example, the method in the fourth aspect may comprise providing a beam source of electromagnetic radiation (e.g. EUV radiation, DUV radiation, i-line radiation, etc.). This may additionally include providing a developable lacquer layer on the wafer. The lithographic transfer may also be based at least partly on the radiation source and the providing of the developable lacquer layer. It is possible here, for example, by means of the radiation from the radiation source, to image the pattern onto the lacquer layer (in a transformed form). The methods described herein may, for example, be recorded in written form. This can be achieved, for example, by means of a digital file, analogously (for example in paper form), in a user handbook, in a formula (recorded, for example, in a device and/or a computer at a semiconductor factory). It is also conceivable that a written protocol is compiled on execution of one of the methods described herein. The protocol may enable, for example, proof of the execution of the method and details thereof (for example the formula) at a later juncture (for example in the course of a fault assessment, a material review board, an audit, etc.). The protocol may comprise, for example, a protocol file (i.e. log file) which can be recorded, for example, in a device and/or computer.

A fifth aspect relates to a computer program comprising instructions which, when executed by a computer system, cause the computer system to implement a method according to the first aspect.

A further aspect relates to the aforementioned apparatus with a memory which comprises the computer program. Further, the apparatus may have a means for executing the computer program. Alternatively, it is possible for the computer program to be stored elsewhere (e.g., in a cloud) and for the apparatus to merely have means for receiving instructions that arise from executing the program elsewhere. Either way, this may allow the method to run in automated or autonomous fashion within the apparatus. Consequently, it is also possible to minimize the intervention, for example by an operator, and so it is possible to minimize both the costs and the complexity when processing masks.

### 4. Brief description of the figures

The following detailed description describes technical background information and working examples of the invention with reference to the figures, which show the following:
- **Fig. 1**: gives a schematic illustration in a top view of an illustrative repair situation for a lithography object.
- **Fig. 2**: shows a schematic diagram of an illustrative method of the invention.
- **Figs 3a-c**: give in a schematic illustration, in a cross section, by way of example, operations in a method of the invention.
- **Fig. 4**: shows a schematic view of an illustrative apparatus of the invention.
- **Fig. 5**: shows a schematic of a cross section through a pattern element of a lithography object, wherein the pattern element can be processed by an illustrative method of the invention.

### 5. Detailed description of possible embodiments

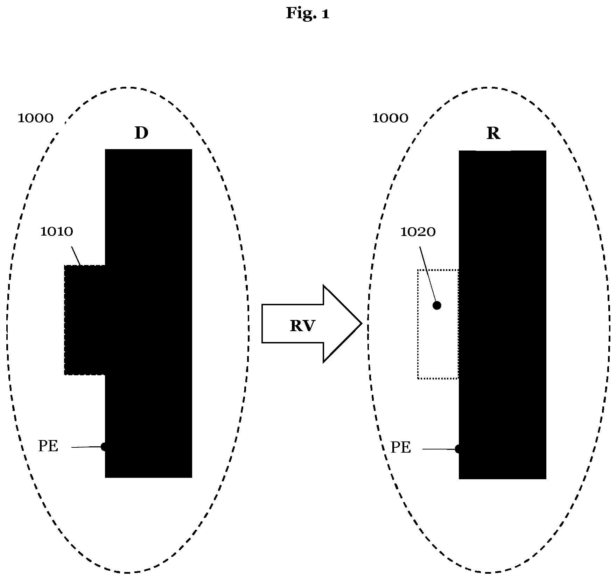

Fig. 1 gives a schematic illustration in a top view of an illustrative repair situation for a lithography object. The lithography object may comprise here a lithographic mask suitable for any lithography method (e.g. EUV lithography, DUV lithography, i-line lithography, nanoimprint lithography etc.). In one example, the lithography mask may comprise an EUV mask, a DUV mask, an i-line lithography mask and/or a nanoim-printing stamp. In addition, the lithography object may comprise a binary mask (e.g. a chromium mask, an OMOG mask), a phase mask (e.g. a chromium-free phase mask, an alternating phase mask (e.g. a rim phase mask), a half-tone phase mask, a tritone phase mask and/or a reticle (for example with pellicle). The lithography mask may be used, for example, in a lithography method for the production of semiconductor chips.

The lithography object may comprise here (unwanted) defects. For example, a defect may be caused in the production of the object. In addition, a defect may also be caused by (lithography) processing of the object, a process deviance in the (lithography) processing, transport of the object, etc. On account of the usually costly and complex production of a lithography object, the defects are therefore usually repaired.

In the working examples described herein, for illustrative purposes, an EUV mask is frequently employed here as an example of a lithography object. However, rather than the EUV mask, any lithography object is conceivable (for example as described herein).

Fig. 1 can show, in schematic form, in a top view, two local states D, R of a detail 1000 of an EUV mask in the course of a repair of a defect in the mask. The detail 1000 shows part of a pattern element PE of the EUV mask. The pattern element PE may also be regarded as a pattern element (or else as a pattern structure) of the EUV mask. The pattern element PE may be part of a designed pattern which can be transferred to a wafer, for example, via a lithography method. The local state D shows an opaque defect 1010 adjoining the pattern element PE. The opaque defect 1010 may feature, for example, excess (opaque) material that should not be present at the defect side after mask development. The excess (opaque) material may correspond, for example, to an opaque material of the pattern element PE, or else to any other material of a layer of the pattern element PE (as described herein). In relation to Fig. 1 (state D), a defect-free pattern element PE in the detail 1000 would have to have a square shape, but it is clear that this target state does not exist as a result of the opaque defect 1010. A repair procedure RV therefore removes the excess (opaque) material in the region of the opaque defect 1010, such that a repaired state R of the pattern element PE can be created. Thus, it is shown in state R that no opaque effect occurs any longer in the original defect region 1020 (i.e. at the original site in the opaque defect) and there is no longer any excess (opaque) material. The removal of the defect 1010 accordingly reestablishes the target state of the rectangular shape of the pattern element PE after a repair operation.

During use in lithography apparatuses or lithography methods, a lithography mask may be subject to extreme physical and chemical environmental conditions. This is especially true of the exposure of EUV masks (and also DUV masks, or other masks as described herein) during a corresponding lithography method, in which the opaque material in particular of a pattern element PE may be subjected to these influences to a significant degree. For example, in the case of EUV exposure, a hydrogen plasma comprising free hydrogen radicals may be released, which can attack the opaque material of the pattern element PE among other materials and cause a material-altering and/or -removing effect. Further damage influences may occur in the EUV lithography process and mask cleaning processes. Damage to the mask material includes, for example, a chemical and physical alteration of the material by (EUV) radiation, temperature, and also a reaction with hydrogen or another reactive hydrogen species (e.g. free radicals, ions, plasma, etc.). The alteration of the material may also be caused by a reaction with purge gases (e.g. N2, extreme clean dry air - XCDA^{®}, noble gases, etc.), in conjunction with the exposure radiation (e.g. EUV radiation, DUV radiation). The damage to the material may likewise arise or be enhanced by downstream processes (for example a mask cleaning operation). The downstream processes may, for example, additionally attack the opaque material of the pattern element PE that has previously been damaged by chemical/physical reactions during the exposure operation, and hence worsen the damage.

Therefore, the specific opaque material used in a pattern element PE may be a chemically resistant material. In particular, ruthenium-containing materials (as described herein) may be employed as resistant material for the pattern element PE in an EUV mask on account of their very high chemical stability. The ruthenium-containing materials may, for example, take the form of RuₐZ_{b} (a, b ≥ 0, Z: one or more further elements with the stoichiometric coefficient b applicable to the respective element). Z here may comprise a metal, nonmetal, semimetal, alkali metal (e.g.Li, Na, K, Rb, Cs).

In addition, Z may comprise an alkaline earth metal (e.g. Be, Mg, Ca, Sr, Ba), a 3rd main group element (e.g. B, Al, Ga, In, Tl), a 4th main group element (e.g. C, Si, Ge, Sn, Pb), a 5th main group element (e.g. N, P, As, Sb, Bi). In addition, Z may comprise a chalcogenide (e.g. O, S, Se, Te), a halogen (e.g. F, Cl, Br, I) a noble gas (atom) (e.g. He, Ne, Ar, Kr, Xe), a transition group element (e.g. Ti, Hr, Hf, V, Nb, Ta, Cr, Mo, W, Mn, Re, Co, Rh, Ir, Ni, Pd, Pt, Cu, Ag, Au, Zn, Cd, Hg).

However, this type of resistance (opaque) material of a pattern element PE or of an EUV mask can make the repair operation RV of an opaque defect 1010 significantly more difficult since the repair operation is to specifically remove the resistant (opaque) material.

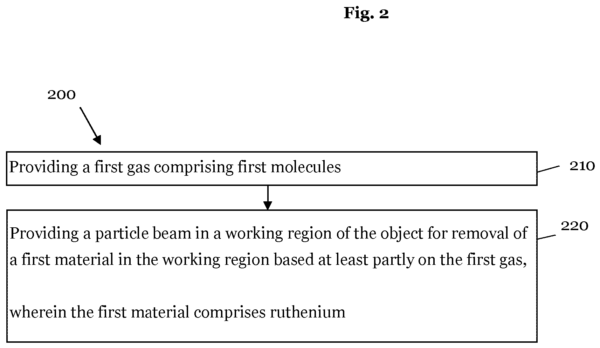

Fig. 2 shows a schematic diagram of an illustrative method 200 of the invention. The method 200 may be employed in order to remove material from an EUV mask. In particular, the method 200 may be employed in order to remove material from an opaque defect 1010 in the course of a repair operation.

The method 200 may comprise here providing 210 of a first gas including first molecules. The first gas here may comprise, for example, XeF₂ as first molecules. In addition, other gases are also conceivable as first gas, as described herein.

Other molecules are also suitable as first molecules of the first gas for the method 200. For example, polar and nonpolar triatomic molecules are conceivable. The first molecules may also comprise molecules that can be split into chlorine or fluorine radicals under suitable reaction conditions and/or additionally, for example, can be split into a further nonpolar species.

In addition, the method 200 may comprise providing 220 of a particle beam in a working region of the object for removal of a first material in the working region based at least partly on the first gas. The first material here may comprise ruthenium. It may also be a characteristic 230 of the method 200 that the first material comprises at least 50 atom per cent of ruthenium, preferably at least 70 atom per cent of ruthenium, especially preferably at least 90 atom per cent of ruthenium. The method 200 may also comprise an electron beam as particle beam, such that electron beam-induced etching of the material by the method 200 may be enabled.

The first material here may especially correspond to the resistant (opaque) material of the EUV mask (as described herein), which is to be removed in the course of the repair of an opaque defect.

The method 200 may also comprise providing a second gas as additive gas that assists the etching process (for example with regard to etch selectivity, etch rate, anisotropy factor, etc.). In particular, in the case of electron beam-induced etching, the first gas used in the method 200 may be XeF₂ and the additive gas H₂O (i.e. water (vapour)). In addition, the second molecules may comprise a dipole moment between 1.6 D and 2.1 D, preferably between 1.7 D and 2 D, more preferably between 1.8 D and 1.95 D, most preferably between 1.82 D and 1.9 D. It is also conceivable that H₂O is combined with nitrogen dioxide (or another oxidative gas) as additive gas.

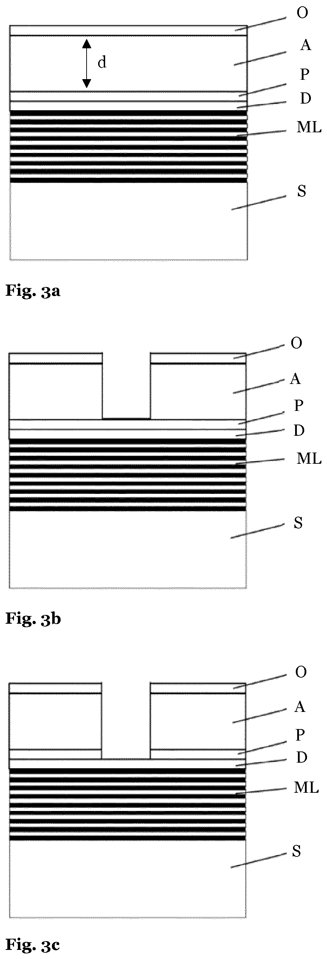

Figs 3a-c give a schematic illustration, in a cross section, by way of example, of procedures in the method 200 that can take place in the course of repair of a defect in a lithography object.

Fig. 3a presents, in schematic form, an illustrative characteristic layer structure of a reflective lithography mask for the UV wavelength region (i.e. an UV mask). The illustrative EUV mask 200 may be designed, for example, for an exposure wavelength in the region of 13.5 nm. For example, the EUV mask may comprise a phase-shifting EUV mask and/or a radiation-absorbing EUV mask. For example, the illustrative characteristic layer structure may be designed to be essentially radiation-absorbing for EUV lithography with a radiation-absorbing EUV mask (as described herein). For example, the illustrative characteristic layer structure may also be designed to be (essentially) phase-shifting for EUV lithography with a phase-shifting EUV mask. The EUV mask may include a substrate S made of a material with a low coefficient of thermal expansion, for example quartz. Other dielectrics, glass materials or semiconducting materials likewise can be used as substrates for EUV masks.

The substrate S may be adjoined by a deposited multilayer film or a reflective layer stack ML including, for example, 20 to 80 pairs of alternating molybdenum (Mo) and silicon (Si) layers, which may also be referred to as MoSi layers. The individual layers of the multilayer film ML may differ in refractive index, giving rise to a Bragg mirror that can reflect incident radiation (e.g. EUV radiation).

In order to protect the reflective layer stack ML, a capping layer D may be applied, for example, atop the uppermost layer of the reflective layer stack ML. The capping layer D may protect the reflective layer stack ML from damage by chemical processes during the production and/or during the use of the EUV mask (for example during a lithography method). The capping layer D may comprise here (elemental) ruthenium, and also elements or compounds of elements that increase reflectivity at wavelength 13.5 nm by not more than 3%. In addition, the capping layer D may comprise Rh, Si, Mo, Ti, TiO, TiO₂, ruthenium compounds, ruthenium alloys, ruthenium oxide, niobium oxide, RuW, RuMo, RuNb, Cr, Ta, nitrides, and also compounds and combinations of the aforementioned materials. The capping layer may further comprise one of the following materials: RuRh, RuZr, RuZrN, RuNbN, RuRhN, RuV, RuVN.

Atop the capping layer D there may be several layers that may include, for example, the layers of the pattern element (i.e. pattern element layers). The pattern element layers may comprise a buffer layer P, an absorption layer A and/or a surface layer O. The properties of the pattern element layers (for example an intrinsic material property of a pattern element layer, a layer thickness of a pattern element layer, etc.) and the geometry of the pattern element PE shaped therefrom may be designed to cause an opaque effect in relation to the exposure wavelength of the EUV mask. For example, the pattern element PE may be designed such that it is opaque (i.e. non-transparent to light or highly light-absorbing) with respect to light radiation having a wavelength of 13.5 nm. The pattern element layers may correspond to the layers of the opaque defect 1010, although the opaque defect 1010 need not necessarily have all the pattern element layers. For example, the opaque defect 1010 may have merely the buffer layer P and the absorption layer A.

The buffer layer P may be present atop the capping layer D. In addition, the absorption layer A may be present atop the buffer layer P. The absorption layer A may be designed to be effective in absorbing the radiation of lithography wavelengths (as described herein). Accordingly, the absorption layer A may make the main contribution to an opaque effect of the pattern element (or of the opaque defect 1010). The optical properties of the absorption layer A can be described, for example, by a complex refractive index that may include a phase shift contribution (i.e. n) and the adsorption contribution (i.e. k). For example, n and k may be regarded as intrinsic material properties of the absorption layer. Only particular chemical elements and/or compounds of chemical elements have advantageous phase-shifting and/or absorptive properties for the corresponding lithography method (e.g. an EUV lithography method). Fig. 3a indicates, by way of example, the layer thickness d of the absorption layer A. The layer thickness d of the absorption layer A (and also a layer thickness of another layer of the mask) is ascertained, for example, along a normal vector in relation to the plane of the mask. In principle, it is also conceivable that the absorption layer A comprises multiple absorption layers including different materials, for example. In addition, the surface layer O may be present atop the absorption layer A. The surface layer O may comprise an antireflection layer, oxidation layer and/or passivation layer. As well as the absorption layer A, it is also possible for the buffer layer P and/or the surface layer O to contribute to the absorption and to the opaque effect of the pattern element PE or of the opaque defect 1010.

In principle, any of the pattern element layers described herein may include the resistant first material mentioned (i.e. ruthenium-containing material). Typically, for example, the absorption layer A includes ruthenium. The first material in the method 200 may accordingly comprise a material of the absorption layer A. In addition, it is alternatively possible, for example, for the buffer layer P or the surface layer O to include ruthenium and hence to constitute the first material in the method 200.

Fig. 3b shows the result of an illustrative method 200 for removal of part of the absorption layer A. The absorption layer A is designed as the first material in the method 200. Initially, part of the surface layer O may first be removed. For example, this can be effected analogously to the method 200 via electron beam-induced etching in a separate step. The surface layer need not necessarily be removed with the first and/or second gas (as described herein). It is also conceivable that the electron beam-induced etching is designed exclusively for the removing of the surface layer (for example with an etching gas matched to the material of the surface layer). After the surface layer O has been removed, it is then possible to remove part of the absorption layer A as the first material in the method 200 (for example to repair an opaque defect). Fig. 3b illustrates selective electron beam-induced etching of the absorption layer A with respect to the buffer layer P. Accordingly, the method 200 may be adjusted such that the etch rate of the absorption layer A is elevated compared to the etch rate of the buffer layer P. For example, the etching selectivity can be adjusted via the properties of the second gas in the method 200 (for example via a suitable choice of the second gas (e.g. water), or the gas flow rate of the second gas). In addition, the etch selectivity can also be adjusted by the properties of the first gas (for example via the choice of first gas (e.g. XeF₂), or via the gas volume flow rate of the first gas). In this example, the buffer layer P accordingly functions as etch stop via the etch selectivity chosen.

Fig. 3c shows a further result of an illustrative method 200 for removal of part of the absorption layer A. Initially, it is possible here (as described herein) to remove a portion of the buffer layer O. After the surface layer O has been removed, it is then possible to remove part of the absorption layer A as the first material in the method 200. It is also possible here to etch a portion of the buffer layer P as intermediate material. Accordingly, the method 200 may be adjusted such that the etch rate of the absorption layer A, and also the etch rate of the buffer layer P, are elevated compared to the etch rate of the capping layer D. The etch rate of the absorption layer A may be in the same order of magnitude as the etch rate of the buffer layer P. The etch selectivity may be adjusted as described herein. As shown in fig. 3c, this can achieve selective electron beam-induced etching of the absorption layer A and of the buffer layer P with respect to the capping layer D. In this example, the capping layer D therefore functions as etch stop via the etch selectivity chosen.

In one example, the surface layer O is not removed separately, but via the same process which is employed for the local removing of the absorption layer A (or of the absorption layer A and the buffer layer P) in a method 200.

It should also be mentioned that the parameter space (e.g. gas parameters of the first/second gas, particle beam parameters) of the method 200 may depend firstly on the layer currently being processed (by the particle beam). This may correspond, for example, to stepwise removal of layers (or materials), with adjustment of the parameter space of the method 200 for each layer (or each of the materials). However, it is also possible that the parameter space of the method 200 does not depend on the layer currently being processed (with the particle beam). This approach too can, for example, remove multiple layers (or materials) successively.

The method 200 can additionally also be employed for a different specific layer structure of the lithography object from that shown in Figs. 3a-c. The specific layer structure of the object (for example the EUV mask) may, as before, include here a capping layer adjoining a reflective layer stack of the object. This capping layer may be adjoined by a first layer. This first layer may be adjoined by a second layer. Proceeding from the substrate, the specific layer structure may accordingly comprise the following layers in this sequence: substrate, reflective layer stack, capping layer, first layer, second layer. The first and second layers may account for one layer of a pattern element here. In one example, the first and second layers are specifically designed as absorption layers for a pattern element (for example in relation to the lithography method). The absorption of the lithography wavelength (as described herein) can be effectively defined here via the two layers (i.e. the first and second layers). For example, the first and second layers may have different thicknesses, in order to configure the optical properties of the lithography object. In a first example of the specific layer structure, the capping layer may include ruthenium and niobium. The first layer here may comprise tantalum, boron and oxygen. The second layer may comprise ruthenium, chromium and nitrogen. In a second example, the specific layer structure is defined in that the capping layer includes essentially ruthenium, while the first layer comprises tantalum, oxygen and nitrogen (e.g. tantalum oxynitride, TaON). In this second example, the second layer of the specific layer structure may comprise ruthenium and oxygen (this may, for example, be ruthenium oxide, which can be referred to, for example, as RuOx).

Based on the specific layer structure described herein, the first material (for the purposes of the method 200 or the method in the first aspect) may correspond to a material of the second layer. The second material (for the purposes of the method 200 or the method in the first aspect) may correspond to a material of the first layer. The third material (for the purposes of the method 200 or the method in the first aspect) may correspond to a material of the capping layer. In one example, the first layer of the specific layer structure too comprises ruthenium (for example as the absorption layer as well). In that case, the material of the first layer may comprise features/properties as described herein for the first material.

For the first example of the specific layer structure, the inventors have recognized here particularly advantageous parameter spaces for the controlled removing of the first material (Ru, Cr, N in this case) and of the second material (Ta, B, O in this case), with use of the third material (the capping layer of Ru, Nb in this case) for determination of the end point of the method. For advantageous results, the first gas used in the test series was XeF₂, and the additive gas H₂O. A first test series comprised the following process properties: a XeF₂ precursor reservoir at a temperature of -15°C, which was used to form the XeF₂ gas, an H₂O precursor reservoir at a temperature of -36°C, which was used to form the H₂O gas, a dwell time of the electron beam of 0.1 µs, a frame refresh rate of 1000 µs. In addition, gas chopping was used here in the providing of the second (additive) gas with a gas chopping ratio of 1:15. In other examples, the two precursor reservoirs may be at different temperatures, for example below 0°C; for example, the XeF₂ precursor reservoir at -30°C to 0°C or -25°C to -5°C; for example, the H₂O precursor reservoir at -50°C to -20°C or -45°C to -25°C. The frame refresh rate in these examples may vary from 0.1 to 10 ms, preferably 0.2 to 5 ms, more preferably 0.5 to 2 ms, where the gas chopping ratio may be chosen within the range from 1:5 to 1:25 or 1:10 to 1:20. Gas chopping comprises here the continuous providing of the additive gas over a particular period t_{X} of a sequence: after the particular period of time t_{X} has elapsed, the provision of the second gas is suspended for time t_{Y} until the sequence has elapsed. The duration of a sequence (i.e. t_{S}) can accordingly be described over the total duration t_{S} = t_{X} + t_{Y}. After the sequence has elapsed, a new sequence is commenced with the described time lapses in the providing of the additive gas, with a repetition of the operation as often as desired (for example up to the end of the method). It is thus possible for the providing of the additive gas to take place in a "pulsed" form (rather than continuous provision). The gas chopping ratio (e.g. 1:15) indicates here the ratio of the provision time t_{X} to the non-provision time t_{Y} of the gas over a sequence. The gas chopping ratio may indicate here the provision time t_{X} and the non-provision time t_{Y} in seconds (for example, a gas chopping ratio of 1:15 may mean that t_{X} is one second and t_{Y} is 15 seconds, where the corresponding sequence t_{S} is 16 seconds).

A second test series was executed with an XeF₂ precursor reservoir at a temperature of -20°C and an H₂O precursor reservoir at a temperature of -34°C, a dwell time of the electron beam of 0.05 µs, a frame refresh rate of 1000 µs. A gas chopping ratio of 1:15 was used here. In other examples, the two precursor reservoirs may be at different temperatures, for example below 0°C: for example, the XeF₂ precursor reservoir at - 40°C to 0°C or -30°C to -15°C; for example, the H₂O precursor reservoir at -50°C to - 20°C or -45°C to -25°C. The frame refresh rate in these examples may vary from 0.1 to 10 ms, preferably 0.2 to 5 ms, more preferably 0.5 to 2 ms, where the gas chopping ratio may be chosen within the range from 1:1 to 1:10, 1:5 to 1:25 or 1:10 to 1:20. A third test series was executed with an XeF₂ precursor reservoir at a temperature of -10°C and an H₂O precursor reservoir at a temperature of -36°C, a dwell time of the electron beam of 0.1 µs, a frame refresh rate of 1000 µs. A gas chopping ratio of 1:1 was used here. In other examples, the two precursor reservoirs may be at different temperatures, for example below 0°C: for example, the XeF₂ precursor reservoir at -20°C to 0°C or -15°C to -5°C; for example, the H₂O precursor reservoir at -50°C to -20°C or - 40°C to -30°C. The frame refresh rate in these examples may be from 0.1 to 10 ms, preferably 0.2 to 5 ms, more preferably 0.5 to 2 ms, where the gas chopping ratio may be chosen within the range from 1:1 to 1:10, 1:5 to 1:25 or 1:10 to 1:20.

For the second example of the specific layer structure, the inventors have likewise recognized advantageous parameter spaces for the controlled removing of the first material (RuOx, i.e. ruthenium oxide, in this case) and of the second material (TaON in this case), with use of the third material (the capping layer of Ru in this case) for determination of the end point of the method. For advantageous results, the first gas used for each test series in the second example was XeF₂, and the additive gas H₂O. Also examined here, however, was what influence an additional oxidative gas (nitrogen dioxide in this case) in the additive gas has on the removing. The test series in the second example were numbered from test series four to test series seven, proceeding from the test series in the first example of the specific layer structure. Thus, a fourth test series was executed with an XeF₂ precursor reservoir at a temperature of -15°C and an H₂O precursor reservoir at a temperature of -36°C, a dwell time of the electron beam of 0.1 µs, a frame refresh rate of 1000 µs. A gas chopping ratio of 1:30 was used here. In other examples, the two precursor reservoirs may be at different temperatures, for example below 0°C: for example, the XeF₂ precursor reservoir at -30°C to 0°C or -20°C to -5°C; for example, the H₂O gas at -50°C to -20°C or -40°C to -30°C. A fifth test series corresponded to the parameters specified herein for the fourth test series, with additional provision of nitrogen dioxide (with a gas volume flow rate of 1.2 sccm). A sixth test series was executed with an XeF₂ precursor reservoir at a temperature of -20°C and an H₂O precursor reservoir at a temperature of -36°C, a dwell time of the electron beam of 0.1 µs, a frame refresh rate of 1000 µs. A gas chopping ratio of 1:30 was used here. In other examples, the two precursor reservoirs may be at different temperatures, for example below 0°C: for example, the XeF₂ precursor reservoir at -40°C to 0°C or -30°C to -10°C; for example, the H₂O precursor reservoir at - 50°C to -20°C or -40°C to -30°C. A seventh test series corresponded to the parameters specified herein for the sixth test series, with additional provision of nitrogen dioxide (with a gas volume flow rate of 1.2 sccm). In a scanning electron micrograph, a sharper edge profile of the etched structures was attributable to the test series that had nitrogen dioxide and water as additive gas. It should also be mentioned that, for the method of processing in the second example of the specific layer structure, the frame refresh rate may also vary from 0.1 to 10 ms, preferably 0.2 to 5 ms, more preferably 0.5 to 2 ms, where the gas chopping ratio may also be chosen within the range from 1:1 to 1:10, 1:5 to 1:25 or 1:10 to 1:20.

In the test series described herein, during the method (i.e. in the removing of the first and second material, and also in processing of the third material with the particle beam), the intensity of the signal of the electrons that were released from the working region was determined. The intensity was determined here depending on the dose of the particle beam (an electron beam in the examples). The dose corresponded here to the dose that was introduced over the course of the method via the region to be etched (the working region), with determination of the intensity via a backscattered electron detector. It was possible here to ascertain that the intensity depends on the material on which the particle beam is acting. It was possible here to assign a particular value (or range of values) of intensity to a particular material or to a layer of the specific layer structure. It was thus possible to monitor the removing of the various layers of the specific layer structure via the progression of intensity as a function of dose. For example, in the case of a (significant) change in intensity (for example a local positive and/or negative rise in the intensity progression), it was possible to conclude that the removing results in a change from a previously exposed layer to an (underlying) different layer which is now also being exposed, but causes a different intensity signal of the electrons. For example, it was possible to detect the material of the previously exposed layer with an intensity I_{X}, and to detect the material of the other layer with an intensity I_{Y}, with I_{Y} < I_{X} (or I_{Y} > I_{X}). In a transition phase, it was possible to detect a decreasing (increasing) intensity between Iₓ and I_{y}, which caused the drop (rise) in the intensity progression. In addition, in the case of a (predominantly) constant progression of intensity, it was possible to conclude, for example, that an exposed layer is being processed. This was attributable to the fact that no (significant) change in intensity was apparent, which could be explained by a change in the material exposed.

These characteristic properties of the intensity progression that are associated, for example, with the change in the expose layer, and also with the processing of an exposed layer, can serve to determine an endpoint of the method.

In addition, for the test series described herein (i.e. test series one to seven), a corresponding etch depth was determined depending on selected (introduced) doses of the particle beam. For this purpose, for a test series, multiple geometrically identical test structures (or identical test areas/working regions to be etched) were subjected to the corresponding method, with the only difference in the dose (introduced) in the various test structures. It was thus possible to assess the influence of the dose (introduced) of the particle beam for the corresponding methods. The etch depths of the test structures were determined by atomic force microscopy here. These items of information were usable for a progression of etch depth as a function of the (introduced) dose for the corresponding methods, with a plot of etch depth on the ordinate and of the selected (introduced) dose on the abscissa. The progression of etch depth likewise enabled conclusions in order to decide the specific layer structure. The (local) rises in the progression of edge depth were determined here by means of linear regression, with the (local) rise corresponding to an etch rate. By virtue of the material-specific differences, the different materials of the specific layer structure also have different etch rates. These differences in etch rates were usable to deduce which characteristic section of the etch profile progression can be assigned to the first layer, to the second layer or to the capping layer.

The method 200 accordingly comprises, in one example, the determining of an endpoint of the method based on a particular etch rate (or a particular difference in etch rates) and/or a particular intensity progression in the signal of the electrons. The determining of the etch rate and/or the intensity progression (as described herein) may, for example, precede the actual removing of the first material (for example in a calibration experiment).

It is also conceivable that the specific layer structure is defined by further layers. For example, it is conceivable that there is at least one buffer layer between the capping layer and the first layer. In this case, the buffer layer may comprise the features of the buffer layer P of Figs 3a-c described herein. In this connection, the buffer layer of the specific layer structure may correspond to the intermediate material (as described herein). The specific layer structure may also be designed such that, as well as the first and second layers, at least a third layer is present, where the third layer may constitute an absorption layer of the pattern element. It is thus possible, for example, for a pattern element to be configured with three or more absorptions layers on the lithography object. For example, the first and second layers may here be attached alternately atop the capping layer (for example, the layer sequence may comprise capping layer, first layer, second layer, first layer, second layer, etc.).

It should be mentioned that the ruthenium-containing absorption layers specified herein may include ruthenium and at least one of the following metals: Nb, Zr, Y, B, Ti, La, Mo, Co, Re. In addition, the ruthenium-containing material may comprise at least one of the following: N, O, H, C.

In addition, the ruthenium-containing material may comprise at least one of the following transition metals: Mo, Ta, W, Ti, Cr, Hf, Ni, V, Zr, Rh, Nb, Pd. In a further example, the ruthenium-containing material may also comprise the following: Cr, Ni, Co, V, Nb, Mo, W, Re, Ta.

In principle, it may also be necessary in a mask repair to produce or to deposit material (as repair material). In the case of mask repair by means of electron beam-induced deposition of ruthenium (for example in the form of RuₐZ_{b}, as described herein), ruthenium oxides or other ruthenium-containing deposits may also result here in unwanted material deposition. Unwanted material deposition may be caused, for example, by off-target strands of the electron beam and secondary electrons generated thereby. In addition, unwanted deposition (of the repair material) may be caused by secondary electrons produced at sites adjacent to the repaired defect, and also by secondary electrons that escape at vertical edges of the process material and propagate to sites adjacent to the repaired defect. It is likewise possible for forwardscattered electrons (FSE) that escape from the flanks of existing material and backscattered electrons (BSE) that escape from the surface in the environment of the repaired site to contribute to unwanted material deposition.

A further application of the method 200 is therefore the removal of material that has been deposited by these mechanisms mentioned on areas adjacent to the repaired defect. In one example, the method 200 therefore also comprises the producing of a repair material.

In the course of production of the repair material, it is possible to use a deposition gas in the electron beam-induced deposition. It is possible here for at least one of the following to be included as deposition gas in the invention: (metal, transition element, main group) alkyls such as cyclopentadienyl (Cp) or methylcyclopentadienyl (MeCp) trimethylplatinum (CpPtMe₃ or MeCpPtMe₃), tetramethyltin SnMe₄, trimethylgallium GaMe₃, ferrocene Cp₂Fe, bisarylchromium Ar₂Cr, ruthenocene Cp₂Ru and other compounds of this kind. In addition, at least one of the following may be included in the invention as first gas: (metal, transition element, main group) carbonyls such as chromium hexacarbonyl Cr(CO)₆, molybdenum hexacarbonyl Mo(CO)₆, tungsten hexacarbonyl W(CO)₆, dicobalt octacarbonyl Co₂(CO)₈, triruthenium dodecacarbonyl Ru₃(CO)₁₂, iron pentacarbonyl Fe(CO)₅ and other compounds of this kind. In addition, one of the following may be included in the invention as first gas: (metal, transition element, main group) alkoxides such as tetraethoxysilane Si(OC₂H₅)₄, tetraisopropoxytitanium Ti(OC₃H₇)₄ and other compounds of this kind.

It is also possible for at least one of the following to be included as deposition gas in the invention: (metal, transition element, main group) halides such as WF₆, WCl₆, TiCl₆, BCl₃, SiCl₄ and other compounds of this kind. In addition, at least one of the following may be included in the invention as deposition gas: (metal, transition element, main group) complexes such as copper bis(hexafluoroacetylacetonate) Cu(C₅F₆HO₂)₂, dimethylgold trifluoroacetylacetonate Me₂Au(C₅F₃H₄O₂), dicarbonylbisdiketonateru-thenium and other compounds of this kind. It is also possible for at least one of the following to be included as deposition gas in the invention: organic compounds such as CO, CO₂, aliphatic or aromatic hydrocarbons, constituents of vacuum pump oils, volatile organic compounds and further such compounds.

The method 200 (or the method in the first aspect) may be executed via the apparatus of the invention described herein. In one example, the apparatus comprises a mask repair apparatus for repair or processing of lithography masks. The apparatus may be used to localize and to repair or remedy mask defects. The apparatus may comprise parts such as the apparatus described in US 2020/103751 A1 (see the corresponding Fig. 3A therein). The apparatus may comprise, for example, a control unit which may, for example, be part of a computer system. The apparatus, in one example, may be configured such that the computer system and/or the control unit controls the process parameters of the method in the first aspect as disclosed herein. This configuration can enable controlled, and also automated, implementation of the method according to the invention as specified herein, for example without manual interventions. This configuration of the apparatus can be achieved or enabled, for example, via the computer program according to the invention as described herein.

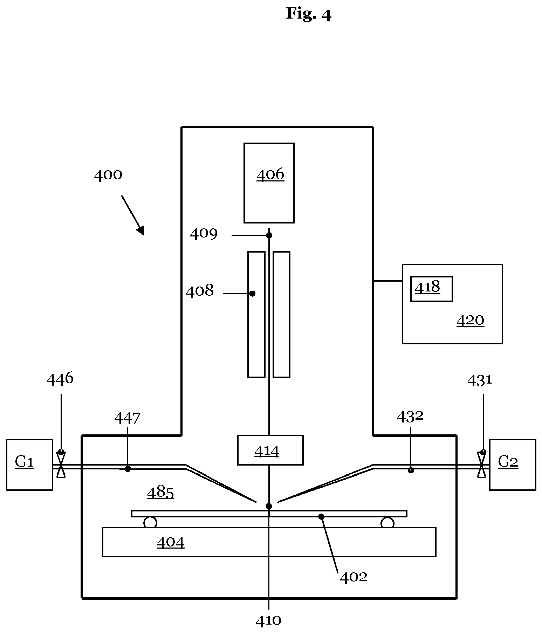

Fig. 4 shows a schematic section of an illustrative apparatus 400 according to the invention. The apparatus 400 may be configured such that it can perform the method 200 or a method in the first and/or second aspect of the invention. In one example, the apparatus 400 of Fig. 4 comprises a mask repair apparatus for repair or processing of lithography masks. The apparatus 400 may be used to localize and to repair or remedy mask defects.

The illustrative apparatus 400 of Fig. 4 may comprise, for example, a scanning electron microscope (SEM) 101 for provision of a particle beam, which, in this example, is an electron beam 409. An electron gun 406 can generate the electron beam 409, which can be directed by one or more beam-forming elements 408 as a focussed electron beam 110 onto a lithography mask 402, which is arranged on a sample stage 404 (or chuck). In addition, the scanning electron microscope can be used to control parameters/properties of the electron beam (e.g. acceleration voltage, dwell time, current, focusing, spot size, etc.) The parameters of the electron beam may be adjusted, for example, in relation to a parameter space of the methods described herein. The electron beam 409 may serve as an energy source for initiating a local chemical reaction in a working region of the lithography mask 402. This may be utilized, for example, for the methods described herein (for example for the implementation of the electron beam-induced etching in the first aspect). In addition, the electron beam 409 may be utilized for imaging of the lithography mask 102. The apparatus 400 may comprise here one or more detectors 414 for detecting electrons (for example secondary electrons, backscattered electrons).

In order to conduct the corresponding methods specified herein, the illustrative apparatus 400 of Fig. 4 may include at least two reservoir vessels for at least two different processing gases or precursor gases. The first reservoir vessel G1 can store the first gas. The second reservoir vessel G2 can store the second gas. In some examples, the temperatures of reservoir vessels G1 and G2 may be controlled independently of one another. The second gas may also be regarded as an additive gas. In addition, in the illustrative apparatus 400, each reservoir vessel G1, G2 has its own gas inlet system 432, 447, which can end with a nozzle close to the point of incidence of the electron beam 410 on the lithography mask 402. It is possible for each reservoir vessel G1 G2 to have its own control valve 446, 431 in order to control the amount of the corresponding gas provided per unit time, i.e. the gas flow rate of the corresponding gas. This can be effected in such a way that the gas volume flow rate is controlled at the point of incidence of the electron beam 410. In addition, the apparatus 400, in one example, may include further reservoir vessels for additional gases that can be added to the method in the first aspect as one or more (additive) gases (e.g. oxidizing agent, reducing agent, halides as described herein). The apparatus 400 in Fig. 4 may include a pump system for generating and maintaining a pressure required in the process chamber 485.

The apparatus 400 may also comprise a control unit (or regulator unit) 418 which may, for example, be part of a computer system 420. The apparatus 400, in one example, may be configured such that the computer system 420 and/or the control unit 418 controls the process parameters of the methods disclosed herein. This configuration can enable controlled or automated implementation of the methods according to the invention specified herein, for example without manual interventions. This configuration of the apparatus 400 can be achieved or enabled, for example, via the computer program according to the invention as described herein.

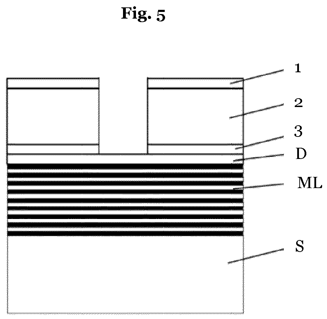

Fig. 5 shows a schematic of a cross section through a pattern element of a lithography object, wherein the pattern element can be processed by an illustrative method of the invention. For example, by means of the method in the first aspect, it is possible to remove the three layers 1, 2, 3 of the pattern element locally in the working region.

An illustrative configuration may, for example, be as follows: The first layer 1 of the pattern element may comprise the first (ruthenium-containing) material (as described herein). A second layer 2 of the pattern element may comprise here the second (tantalum-containing) material (as described herein). A third layer 3 of the pattern element may comprise here the further (tantalum-containing) material (as described herein). The second layer may, for example, be formed from tantalum boroxide (e.g. TaBO) or comprise said material and/or the third layer may, for example, be formed from tantalum boronitride (e.g. TaBN) or comprise said material. It should be mentioned that the layer thicknesses of the first, second and/or third layers of the pattern element are shown merely schematically in Fig. 5. Thus, in one example, the layer thickness of the second layer may also be less than the layer thickness of the first and/or second layer (although other geometric variations are also conceivable). The local removing of at least one of the three layers described herein need not (necessarily) be restricted here to a particular layer thickness sequence of the three layers.

Fig. 5 likewise shows the capping layer D, the reflective layer stack ML and the substrate of the lithography object. The object of Fig. 5 may, for example, be a mask for EUV lithography. For example, the mask may comprise a phase-shifting EUV mask and/or an (essentially) radiation-absorbing EUV mask. The pattern element with the first, second and third layers 1, 2, 3 may be designed here to be correspondingly phase-shifting and/or radiation-absorbing for EUV lithography.

For example, in the case of a defect in the mask, excess material of a layer of the pattern element may be removed in one example of the method described herein. The defect may, for example, be an opaque defect. For the removing of the first layer 1 in the working region, it is possible here to use xenon difluoride with water as first process gas (as described herein). For the removing of the second and/or third layer, it is possible to use xenon difluoride with nitrogen dioxide and tetraethyl orthosilicate as second process gas (as described herein). The capping layer D may comprise ruthenium here. The capping layer D may function here as etch stop in the removing of the second and/or third layer.

## Claims

1. Method (200) for processing a lithography object, comprising:
providing (210) a first gas comprising first molecules;
providing (220) a particle beam in a working region of the object for removal of a first material in the working region based at least partly on the first gas;
wherein the first material corresponds to a material of an absorption layer (A) of a pattern element of the lithography object;
**characterised in that** the first material comprises ruthenium.

2. Method (200) according to claim 1, wherein:
a layer thickness (d) of the first material is at least 20 nm, preferably at least 35 nm, more preferably at least 50 nm, most preferably at least 60 nm.

3. Method (200) according to any of Claims 1 or 2, wherein the first material further comprises at least a second element, the second element preferably comprising a metal and/or a semiconductor.

4. Method (200) according to Claim 3, wherein the second element comprises at least one of the following: tantalum, chromium, nitrogen, oxygen; and
wherein the ruthenium preferably forms a chemical compound with the second element.

5. Method (200) according to any of Claims 1 to 4, wherein the method is effected in such a way that a second material adjoining the first material is at least partly exposed in the working region by the removing, wherein the second material preferably comprises tantalum and/or a tantalum compound.

6. Method (200) according to Claim 5, wherein the method further comprises removing the second material in the working region.

7. Method (200) according to Claim 6, wherein the method is effected in such a way that a third material adjoining the second material is at least partly exposed in the working region by the removing of the second material, and wherein the third material preferably comprises ruthenium.

8. Method (200) according to any of Claims 1 to 7, wherein the first molecules comprise a halogen atom, such as a noble gas halide, wherein the noble gas halide comprises at least one of the following: xenon difluoride, XeF₂, xenon dichloride, XeCl₂, xenon tetrafluoride, XeF₄, xenon hexafluoride, XeF₆.

9. Method (200) according to any of Claims 1 to 8, wherein the method further comprises:
providing a second gas comprising second molecules, wherein the removing of the first material is also based at least partly on the second gas;
wherein a dipole moment associated with the second molecules preferably comprises at least 1.6 D, preferably at least 1.7 D, more preferably at least 1.8 D, most preferably at least 1.82 D; and
wherein the second molecules preferably comprise water, H₂O, and/or heavy water, D₂O.

10. Method (200) according to any of Claims 1 to 9, wherein the method is effected in such a way that a defect of the object is repaired.

11. Method (200) according to any of Claims 1 to 10, wherein the object comprises an EUV mask and/or a DUV mask.

12. Apparatus (400) for processing a lithography object, comprising:
means (G1, 432) of providing a first gas;
means (406, 408, 409) of providing a particle beam in a working region of the object, wherein the apparatus (400) is configured to perform a method according to any of Claims 1 to 11.

13. Lithography object, wherein the object has been processed by a method according to any of Claims 1 to 12.

14. Method for processing of a semiconductor-based wafer, comprising:
lithographic transferring of a pattern associated with a lithography object to the wafer, wherein the object has been processed by a method according to any of Claims 1 to 11.

15. Computer program comprising instructions which, when they are executed by a computer system, cause the computer system to perform a method according to any of Claims 1 to 11.

## Patentansprüche

1. Verfahren (200) zum Bearbeiten eines Objekts für die Lithografie umfassend:
Bereitstellen (210) eines ersten Gases, welches erste Moleküle umfasst;
Bereitstellen (220) eines Teilchenstrahls auf einem Arbeitsbereich des Objekts zum Entfernen eines ersten Materials in dem Arbeitsbereich basierend zumindest teilweise auf dem ersten Gas;
wobei das erste Material einem Material einer Absorptionsschicht (A) eines Musterelements des Objekts für die Lithografie entspricht;
**dadurch gekennzeichnet, dass** das erste Material Ruthenium umfasst.

2. Verfahren (200) nach Anspruch 1, wobei:
eine Schichtdicke (d) des ersten Materials mindestens 20 nm, bevorzugt mindestens 35 nm, weiter bevorzugt mindestens 50 nm, am meisten bevorzugt mindestens 60 nm, beträgt.

3. Verfahren (200) nach Anspruch 1 oder 2, wobei das erste Material ferner mindestens ein zweites Element umfasst, wobei das zweite Element bevorzugt ein Metall und/oder einen Halbleiter umfasst.

4. Verfahren (200) nach Anspruch 3, wobei das zweite Element mindestens eines der folgenden umfasst: Tantal, Chrom, Stickstoff, Sauerstoff; und
wobei das Ruthenium bevorzugt mit dem zweiten Element eine chemische Verbindung bildet.

5. Verfahren (200) nach einem der Ansprüche 1 bis 4, wobei das Verfahren derart erfolgt, dass ein zweites Material, welches an das erste Material angrenzt, durch das Entfernen zumindest teilweise in dem Arbeitsbereich freigelegt wird, wobei das zweite Material bevorzugt Tantal und/oder eine Tantalverbindung umfasst.

6. Verfahren (200) nach Anspruch 5, wobei das Verfahren ferner das Entfernen des zweiten Materials in dem Arbeitsbereich umfasst.

7. Verfahren (200) nach Anspruch 6, wobei das Verfahren derart erfolgt, dass ein drittes Material, welches an das zweite Material angrenzt, durch das Entfernen des zweiten Materials zumindest teilweise in dem Arbeitsbereich freigelegt wird, und das dritte Material bevorzugt Ruthenium umfasst.

8. Verfahren (200) nach einem der Ansprüche 1 bis 7, wobei die ersten Moleküle ein Halogenatom, wie ein Edelgashalogenid, umfassen, wobei das Edelgashalogenid mindestens eines der folgenden umfasst: Xenondifluorid, XeF₂, Xenondichlorid, XeCl₂, Xenontetrafluorid, XeF₄, Xenonhexafluorid, XeF₆.

9. Verfahren (200) nach einem der Ansprüche 1 bis 8, wobei das Verfahren ferner umfasst:
Bereitstellen eines zweiten Gases, welches zweite Moleküle umfasst, wobei das Entfernen des ersten Materials ferner zumindest teilweise auf dem zweiten Gas basiert;
wobei ein Dipolmoment, welches mit den zweiten Molekülen assoziiert ist, mindestens 1,6 D, bevorzugt mindestens 1,7 D, weiter bevorzugt mindestens 1,8 D, am meisten bevorzugt mindestens 1,82 D, umfasst; und
wobei die zweiten Moleküle bevorzugt Wasser, H₂O, und/oder schweres Wasser, D₂O umfassen.

10. Verfahren (200) nach einem der Ansprüche 1 bis 9, wobei das Verfahren derart erfolgt, dass ein Defekt des Objekts repariert wird.

11. Verfahren (200) nach einem der Ansprüche 1 bis 10, wobei das Objekt eine EUV-Maske und/oder eine DUV-Maske umfasst.

12. Vorrichtung (400) zum Bearbeiten eines Objekts für die Lithografie umfassend:
Mittel (G1, 432) zum Bereitstellen eines ersten Gases;
Mittel (406, 408, 409) zum Bereitstellen eines Teilchenstrahls auf einem Arbeitsbereich des Objekts, wobei die Vorrichtung (400) konfiguriert ist, ein Verfahren nach einem der Ansprüche 1 bis 11 durchzuführen.

13. Objekt für die Lithografie, wobei das Objekt mit einem Verfahren nach einem der Ansprüche 1 bis 12 bearbeitet wurde.

14. Verfahren zum Bearbeiten eines halbleiterbasierten Wafers umfassend:
lithografisches Transferieren eines mit einem Objekt für die Lithografie assoziierten Musters auf den Wafer, wobei das Objekt mit einem Verfahren nach einem der Ansprüche 1 bis 11 bearbeitet wurde.

15. Computerprogramm, umfassend Anweisungen, die, wenn sie von einem Computersystem ausgeführt werden, das Computersystem veranlassen, ein Verfahren nach einem der Ansprüche 1 bis 11 durchzuführen.

## Revendications

1. Procédé (200) de traitement d'un objet lithographique, comprenant :
la fourniture (210) d'un premier gaz comprenant des premières molécules ;
la fourniture (220) d'un faisceau de particules dans une zone de travail de l'objet pour l'élimination d'un premier matériau dans la zone de travail basée au moins partiellement sur le premier gaz ;
dans lequel le premier matériau correspond à un matériau d'une couche d'absorption (A) d'un élément de motif de l'objet lithographique ;
**caractérisé en ce que** le premier matériau comprend du ruthénium.

2. Procédé (200) selon la revendication 1, dans lequel :
une épaisseur de couche (d) du premier matériau est d'au moins 20 nm, de préférence d'au moins 35 nm, plus préférablement d'au moins 50 nm, le plus préférablement d'au moins 60 nm.

3. Procédé (200) selon l'une quelconque des revendications 1 ou 2, dans lequel le premier matériau comprend en outre au moins un second élément, le second élément comprenant de préférence un métal et/ou un semi-conducteur.

4. Procédé (200) selon la revendication 3, dans lequel le second élément comprend au moins l'un des éléments suivants : tantale, chrome, azote, oxygène ; et
dans lequel le ruthénium forme de préférence un composé chimique avec le second élément.

5. Procédé (200) selon l'une quelconque des revendications 1 à 4, dans lequel le procédé est réalisé de telle sorte qu'un second matériau adjacent au premier matériau est au moins partiellement exposé dans la zone de travail par l'élimination, le second matériau comprenant de préférence du tantale et/ou un composé de tantale.

6. Procédé (200) selon la revendication 5, dans lequel le procédé comprend en outre l'élimination du second matériau dans la zone de travail.

7. Procédé (200) selon la revendication 6, dans lequel le procédé est effectué de telle sorte qu'un troisième matériau adjacent au deuxième matériau est exposé au moins partiellement dans la zone de travail par l'élimination du deuxième matériau, et dans lequel le troisième matériau comprend de préférence du ruthénium.

8. Procédé (200) selon l'une quelconque des revendications 1 à 7, dans lequel les premières molécules comprennent un atome d'halogène, tel qu'un halogénure de gaz noble, dans lequel l'halogénure de gaz noble comprend au moins l'un des éléments suivants : difluorure de xénon, XeF₂, dichlorure de xénon, XeCl₂, tétrafluorure de xénon, XeF₄, hexafluorure de xénon, XeF₆.

9. Procédé (200) selon l'une quelconque des revendications 1 à 8, dans lequel le procédé comprend en outre :
la fourniture d'un second gaz comprenant des secondes molécules, l'élimination du premier matériau étant également basée au moins partiellement sur le second gaz ;
dans lequel un moment dipolaire associé aux secondes molécules comprend de préférence au moins 1,6 D, de préférence au moins 1,7 D, plus préférablement au moins 1,8 D, le plus préférablement au moins 1,82 D ; et
dans lequel les secondes molécules comprennent de préférence de l'eau, H₂0 et/ou de l'eau lourde, D₂0.

10. Procédé (200) selon l'une quelconque des revendications 1 à 9, dans lequel le procédé est effectué de telle sorte qu'un défaut de l'objet est réparé.

11. Procédé (200) selon l'une quelconque des revendications 1 à 10, dans lequel l'objet comprend un masque EUV et/ou un masque DUV.

12. Appareil (400) pour le traitement d'un objet lithographique, comprenant :
un moyen (G1, 432) de fourniture d'un premier gaz ;
un moyen (406, 408, 409) de fourniture d'un faisceau de particules dans une zone de travail de l'objet, dans lequel l'appareil (400) est configuré pour réaliser un procédé selon l'une quelconque des revendications 1 à 11.

13. Objet lithographique, dans lequel l'objet a été traité par un procédé selon l'une quelconque des revendications 1 à 12.

14. Procédé de traitement d'une plaquette à base de semi-conducteur, comprenant :
un transfert lithographique d'un motif associé à un objet lithographique sur la plaquette, dans lequel l'objet a été traité par un procédé selon l'une quelconque des revendications 1 à 11.

15. Programme informatique comprenant des instructions qui, lorsqu'elles sont exécutées par un système informatique, amènent le système informatique à réaliser un procédé selon l'une quelconque des revendications 1 à 11.
